# EUROPÄISCHE PATENTSCHRIFT

(11) **EP 1 900 264 B1**
(45) Veröffentlichungstag und Bekanntmachung des Hinweises auf die Patenterteilung: **01.05.2013**
(21) Anmeldenummer: 06762396.7
(22) Anmeldetag: 04.07.2006
(51) Int. Cl.: H05K 1/18, H05K 1/14

(54) **LEITERPLATTEN-MEHRSCHICHTAUFBAU MIT INTEGRIERTEM ELEKTRISCHEM BAUTEIL UND HERSTELLUNGSVERFAHREN**
MULTILAYER PRINTED CIRCUIT BOARD STRUCTURE COMPRISING AN INTEGRATED ELECTRICAL COMPONENT, AND PRODUCTION METHOD THEREFOR
STRUCTURE MULTICOUCHE DE PLAQUETTES AYANT UN COMPOSANT ELECTRIQUE INTEGRE, ET SON PROCEDE DE PRODUCTION

(30) Priorität: 04.07.2005 DE 102005032489
(43) Veröffentlichungstag der Anmeldung: 19.03.2008
(73) Patentinhaber: Schweizer Electronic AG, 78713 Schramberg (DE)
(72) Erfinder: OCKENFUSS, Ulrich, 77761 Schiltach (DE); GOTTWALD, Thomas, 78655 Dunningen-Seedorf (DE)
(74) Vertreter: Hössle Patentanwälte Partnerschaft
(86) Internationale Anmeldenummer: PCT/EP2006/006511
(87) Internationale Veröffentlichungsnummer: WO 2007/003414

(56) Entgegenhaltungen:
- EP-A2- 0 574 207
- US-A- 5 401 688
- US-A- 5 426 263
- US-A1- 2003 057 544
- US-A1- 2004 229 446
- US-A1- 2006 017 133

## Beschreibung

Die Erfindung bezieht sich auf einen Leiterplatten-Mehrschichtaufbau nach dem Oberbegriff des Anspruchs 1 sowie auf ein zugehöriges Herstellungsverfahren. Der Begriff elektrisches Bauteil umfasst hierbei auch elektronische Bauteile.

Leiterplatten-Mehrschichtaufbauten mit einem Schichtstapel aus mehreren elektrisch isolierenden und/oder mit Leiterbahnstrukturen versehenen Schichten und wenigstens einem passiven oder aktiven elektrischen Bauteil im Inneren des Schichtstapels gewinnen in jüngerer Zeit immer mehr an Bedeutung, um passive elektrische Bauteile, wie Kondensatoren und Widerstände, und/oder aktive elektrische Bauteile, wie Halbleiterchips, im Inneren einer Leiterplatte vom sogenannten Mehrschicht- oder Multilayertyp zu integrieren. Der Mehrschichtaufbau umfasst einen Schichtstapel aus mehreren übereinanderliegenden, elektrisch isolierenden bzw. dielektrischen Schichten, z.B. aus einem Prepreg-Harzmaterial, mit zwischenliegenden elektrischen Leiterstrukturebenen, die geeignete Trägerschichten mit aufgebrachten Leiterbahnstrukturen beinhalten. Der Schichtstapel wird z.B. durch Laminieren bzw. Verpressen unter Verwendung dielektrischer Prepreg-Schichten fertiggestellt, wobei wenigstens ein Teil der übereinandergelegten Schichten ein- oder beidseitig mit einer elektrisch leitenden Schicht versehen ist, die vor dem Übereinanderlegen zum Schichtstapel in ein gewünschtes elektrisches Leiterbild strukturiert wird. Häufig wird für diesen Zweck für sogenannte Innenlagen, d.h. im Inneren des Schichtstapels befindliche, mit Leiterbahnstrukturen versehene Schichten, ein Epoxidharz als Trägerschichtmaterial mit einer Kupferkaschierung benutzt. Zur Strukturierung der sogenannten Außenlagen, d.h. der außenliegenden, mit Leiterbahnstrukturen versehenen Schichten, wird meist auf eine dielektrische Prepregschicht eine Kupferfolie aufgelegt, die durch den Verpressvorgang fest mit der Prepregschicht verbunden wird.

Für eine solche Integration eines aktiven und/oder passiven elektrischen Bauteils in eine Leiterplatte ist es bekannt, selbiges auf einer mit Leiterbahnen versehenen, elektrisch isolierenden Unterlagenschicht in einem leiterbahnfreien Bereich zu fixieren, bevor dann eine oder mehrere weitere Schichten zur Fertigstellung des Schichtstapels aufgebracht werden und der Gesamtaufbau zusammenlaminiert bzw. verpresst wird. Dabei schließt sich an die das Bauteil tragende Unterlagenschicht üblicherweise eine nächste dielektrische Schicht an, die ganzflächig ausgeführt oder im Bereich des elektrischen Bauteils mit einem Fenster- oder Ausnehmungsbereich versehen ist. Dabei wird vorliegend unter einem Fenster eine die betreffende Schicht vollständig durchdringende Öffnung verstanden, unter einer Ausnehmung hingegen eine einseitig nur in eine Tiefe kleiner als die Schichtdicke in der betreffenden Schicht gebildete Aussparung. Die Kontaktierung von Anschlusskontaktstellen des elektrischen Bauteils zu Leiterstrukturen auf der Unterlagenschicht oder zu Leiterstrukturen in anderen Ebenen des Schichtstapels erfolgt mit Hilfe von Durchkontakten, worunter vorliegend der Einfachheit halber auch Sacklochkontakte verstanden werden sollen, die auf den Kontaktstellen enden. Alternativ wird das elektrische Bauteil in einem elektrischen Kontaktierungsbereich der Unterlagenschicht auf dieser fixiert und direkt mit dortigen Leiterstrukturen elektrisch verbunden. Leiterplatten-Mehrschichtaufbauten dieser verschiedenen Typen sind beispielsweise in der Offenlegungsschrift DE 196 27 543 A1, der Patentschrift EP 1 230 680 B1 und dem Zeitschriftenaufsatz W. Bauer und S. Purger, Integration aktiver und passiver Bauelemente in die Leiterplatte - Alles inklusive -, EPP November 2003, Seite 48 beschrieben.

In der Offenlegungsschrift DE 31 25 518 A1 ist eine dünne Verdrahtungsanordnung zum Verbinden elektrischer Bauteile mit einer äußeren Schaltung beschrieben, die ein Substrat zur Aufnahme des elektrischen Bauteils, eine auf dem Substrat angeordnete erste isolierende Schicht aus einem organischen Material, eine auf der ersten isolierenden Schicht ausgebildete und mit dem elektrischen Bauteil verbundene Verdrahtung, eine auf der ersten isolierenden Schicht angeordnete zweite isolierende Schicht aus einem organischen Material und auf der ersten isolierenden Schicht angeordnete Anschlüsse umfasst, die in der zweiten isolierenden Schicht freiliegen und mit der Verdrahtung verbunden sind. Als Substrat wird ein metallisches oder keramisches Substrat mit einer Ausnehmung verwendet, in der das elektrische Bauteil aufgenommen wird. Die auf der ersten isolierenden Schicht ausgebildete Verdrahtung kontaktiert an der Oberseite des elektrischen Bauteils vorgesehene Anschlüsse. In einer unter Bezugnahme auf die Patentschrift US 3.763.404 beschriebenen Ausführungsform ist die Verdrahtung für das Bauteil auf einer Oberseite eines flexiblen Verdrahtungssubstrats gebildet, das mit einem Fensterbereich zur Kontaktierung des unterhalb des Niveaus des Verdrahtungssubstrats angeordneten elektrischen Bauteils versehen ist, d.h. Anschlussstrukturen der Verdrahtung sind durch den Fensterbereich hindurch zu oberseitigen Anschlussstellen des Bauteils geführt. Diese Kontaktierung des Bauteils wird gleichzeitig zur mechanischen Vormontage des Bauteils an der Verdrahtung genutzt, d.h. Verdrahtungssubstrat, Verdrahtung und Bauteil werden z.B. durch einen kontinuierlichen Folienbandprozess vorgefertigt.

In der Patentschrift DE 690 31 350 T2 ist eine elektronische Mehrschichtpackung mit einem aus einer Vielzahl übereinanderliegender Isolier- und Signal-/Bezugsspannungsschichten bestehenden keramischen Mehrschichtsubstrat offenbart, das an seiner Oberseite eine oder mehrere Ausnehmungen zum Aufnehmen eines oder mehrerer nebeneinander angeordneter Halbleiterchips beinhaltet. Der oder die in der jeweiligen Ausnehmung befindlichen Chips sitzen dort auf einer am Boden der Ausnehmung gebildeten Bindemittelschicht auf, die z.B. aus einer eutektischen Goldlegierung oder einem Epoxid- oder Polyimidmaterial gebildet ist. Im Fall mehrerer in einer Ausnehmung zu platzierender Chips sind diese Teil einer in die Ausnehmung eingebrachten Chipstruktur, die zusätzlich Zwischen- und Innerchip-Verdrahtungsebenen über den Chips beinhaltet, die aus mehrfachen Leitungs-/Metallzwischenverbindungen und zwischengefügten Isolierlagen bestehen. Auf die mit dem oder den eingebrachten Chips versehene Substratoberseite ist eine Mehrschicht-Dünnfilmstruktur aus einer Vielzahl von Isolierschichten und Metallisierungsschichten aufgebracht, wobei die Metallisierungsschichten über Durchkontakte mit oberseitigen Anschlussstellen des jeweiligen Chips bzw. mit den Zwischen- und Innerchip-Verdrahtungsebenen der Chipstruktur elektrisch verbunden sind.

In der Patentschrift US 5.401.688 ist ein Leiterplatten-Mehrschichtaufbau mit einem Schichtstapel aus mehreren mit Leiterbahnstrukturen versehenen Schichten offenbart, in den mindestens ein Halbleiterchip zwischen zwei dieser Schichten eingebettet ist. Beim Laminierungsprozess des mehrlagigen Leiterplatten-Mehrschichtaufbaus werden Bondhügel des Chips elektrisch mit dazu ausgerichteten Leiterstrukturen der benachbarten Schicht kontaktiert.

EP 0 574 207 A2 offenbart einen Leiterplatten-Mehrschichtaufbau mit einem Schichtstapel aus mehreren elektrisch isolierenden und/oder mit Leiterbahnstrukturen versehenen Schichten und einem Insertstück im Inneren des Schichtstapels, das sich lateral nur in einem Teilbereich der Flächenausdehnung des Schichtstapels erstreckt und wenigstens ein darauf montiertes, passives oder aktives elektrisches Bauteil und eine zugehörige Umverdrahtung aufweist, wobei das Insertstück zwischen zwei ganzflächigen, elektrisch isolierenden Harz-Schichten eingebettet ist, die das Insertstück beidseitig abdecken, wobei das Insertstück allseitig spaltfrei von Harzmaterial umschlossen ist.

Der Erfindung liegt als technisches Problem die Bereitstellung eines Leiterplatten-Mehrschichtaufbaus der eingangs genannten Art und eines zugehörigen Herstellungsverfahrens zugrunde, die es ermöglichen, ein oder mehrere elektrische Bauteile im Inneren des Mehrschichtaufbaus mit relativ geringem Aufwand und hoher Funktionszuverlässigkeit zu integrieren.

Die Erfindung löst dieses Problem durch die Bereitstellung eines Leiterplatten-Mehrschichtaufbaus mit den Merkmalen des Anspruchs 1 und eines Herstellungsverfahrens mit den Merkmalen des Anspruchs 19.

Beim erfindungsgemäßen Leiterplatten-Mehrschichtaufbau ist das Insertstück mit seiner gegenüber dem Schichtstapel geringeren Flächenausdehnung allseitig, auch lateral, vollständig eingebettet, und zwar von zwei abdeckenden Prepeg- oder Flüssigharz-Schichten, einer Prepreg- oder Flüssigharzunterlagenschicht einerseits und einer Prepreg- oder Flüssigharzdecklagenschicht andererseits, und von Harzmaterial, das sich beim Verpressen oder Laminieren des Aufbaus in an das Insertstück angrenzenden Prepeg- oder Flüssigharz-Schichtbereichen verflüssigt und dadurch Spalte oder Zwischenräume zwischen dem Insertstück und benachbarten Bereichen des Schichtstapels verfüllt bzw. ausfüllt. Dadurch lässt sich das Insertstück komplett und spaltfrei in eine homogene Harzumgebung einbetten.

Es versteht sich, dass die im Schichtstapel verwendeten Flüssigharz- oder Prepreg-Schichten nach dem Verpressen oder Laminieren des Aufbaus entsprechend ausgehärtete, elektrisch isolierende bzw. dielektrische Schichten bilden, wie dem Fachmann geläufig. Der Übersichtlichkeit halber werden diese Schichten vorliegend auch in ihrem endfertigen, ausgehärteten Zustand weiterhin als Flüssigharz- bzw. Prepreg-Schichten bezeichnet.

In einer Weiterbildung der Erfindung nach Anspruch 2 weist wenigstens eine der beiden das Insertstück abdeckenden Flüssigharz- bzw. Prepreg-Schichten eine Ausnehmung auf, in der das Insertstück oder das oder die auf ihm montierten Bauteile Platz finden, d.h. mit wenigstens einem Teil ihrer Höhenerstreckung aufgenommen werden können. Dies kann das Aufnehmen von Insertstücken bzw. Bauteilen mit etwas größerer Höhe erleichtern, ist aber gerade auch für empfindliche Insertstücke bzw. Bauteile geringer Dicke von Vorteil, um für diese eine mechanische Druckentlastung beim Press-/Laminiervorgang bereitzustellen.

In einer weiteren vorteilhaften Weiterbildung der Erfindung ist gemäß Anspruch 3 zwischen den beiden das Insertstück abdeckenden Flüssigharz- oder Prepreg-Schichten eine Flüssigharz- oder Prepreg-Zwischenschicht vorgesehen, die ein Fenster im Bereich des Insertstücks oder wenigstens eines auf ihm montierten Bauteils aufweist. Auch diese Realisierungsvariante der Erfindung kann insbesondere für Insertstücke bzw. darauf montierte elektrische Bauteile mit relativ großer Höhe, z.B. wenn letztere in der Größenordnung der typischen Schichtdicken der einzelnen Schichten des Schichtstapels liegt, aber auch für dünne, druckempfindliche Insertstücke bzw. darauf montierte elektrische Bauteile von Vorteil sein. Die Zwischenschicht vermeidet stärkere Auswölbungen der abdeckenden Flüssigharz- oder Prepreg-Schichten im Fall eines relativ hohen Insertstücks bzw. darauf montierten elektrischen Bauteils und sorgt bei dünnen druckempfindlichen Inserts bzw. darauf montierten Bauteilen für eine Druckentlastung beim Verpressen des Aufbaus. Die komplette und spaltfreie Einbettung des Insertstücks in beim Verpressen oder Laminieren des Aufbaus verflüssigtes, angrenzendes Harzmaterial bleibt gewährleistet, wobei letzteres in diesem Fall wenigstens teilweise auch aus der Zwischenschicht stammen kann.

In einer Weiterbildung der Erfindung nach Anspruch 4 sind die beiden das Insertstück abdeckenden Flüssigharz- oder Prepreg-Schichten und/oder die Flüssigharz- oder Prepreg-Zwischenschicht mehrlagig gebildet und beinhalten dabei wenigstens zwei Flüssigharz- oder Prepreg-Schichtlagen. Dabei kann je nach Fall die Zwischenschicht auch eine Flüssigharz- oder Prepreg-Schichtlage einer der beiden das Insertstück abdeckenden Flüssigharz- oder Prepreg-Schichten darstellen. Bei mehrlagigem Aufbau kann eine Ausnehmung in einer der beiden Flüssigharz- oder Prepreg-Schichten im Bereich des Insertstücks oder eines auf ihm montierten Bauteils z.B. dadurch realisiert sein, dass wenigstens eine der Schichtlagen auf der dem Insertstück zugewandten Seite der betreffenden Flüssigharz- oder Prepreg-Schicht mit einem Fenster versehen ist. Eine anschließende, durchgehende Schichtlage schließt dann den vom Fenster gebildeten Aufnahmeraum in Schichtstapelrichtung ab. Bei Bedarf kann optional in dieser abdeckenden Schichtlage zusätzlich noch eine Ausnehmung vorgesehen sein.

In einer Weiterbildung der Erfindung nach Anspruch 5 befindet sich zwischen den beiden das Insertstück abdeckenden Flüssigharz- oder Prepreg-Schichten wenigstens eine mit Leiterbahnstrukturen versehene Schicht, d.h. eine Innenlage, die ein Fenster im Bereich des Insertstücks oder des oder der auf ihm montierten Bauteile aufweist. Mit anderen Worten erstreckt sich in diesem Ausführungsbeispiel der Aufnahmeraum für das Insertstück bzw. das betreffende Bauteil durch eine Innenlage hindurch, wodurch auch Insertstücke bzw. darauf montierte Bauteile mit vergleichsweise großer Höhe in den Schichtstapel vorteilhaft integriert werden können. Das spaltfreie Einbetten in Harzmaterial aus angrenzenden Flüssigharz- oder Prepreg-Schichtbereichen ist auch in diesem Ausführungsbeispiel gegeben, wobei in diesem Fall das beim Verpressen oder Laminieren des Aufbaus verflüssigte Harzmaterial aus angrenzenden Flüssigharz- oder Prepreg-Schichtbereichen auch jeglichen lateralen Spalt zwischen dieser Innenlage und dem Insertstück bzw. dem darauf montierten Bauteil vollständig ausfüllt.

In einer Weiterbildung nach Anspruch 6 ist das wenigstens eine elektrische Bauteil auf einem Bauteilmontageplatz einer Umverdrahtungsträgerschicht des Insertstücks montiert, auf der auch die Umverdrahtung vorgesehen ist, wobei sich letztere in einer weiteren Ausgestaltung gemäß Anspruch 7 auf der gleichen Seite dieser Schicht befindet wie der Bauteilmontageplatz. Das Insertstück befindet sich im Inneren des Schichtstapels und erstreckt sich lateral nur in einem Teilbereich der Flächenausdehnung des Schichtstapels. Mit anderen Worten ist das elektrische Bauteil in diesem Fall Bestandteil eines Insertstücks, das in das Innere des Schichtstapels integriert ist und eine Trägerschicht mit Umverdrahtungsfunktion für das elektrische Bauteil beinhaltet. In vorteilhafter Ausgestaltung kann gemäß Anspruch 8 eine beidseitige Bauteilbestückung mit jeweils zugehöriger Umverdrahtung für das Insertstück vorgesehen sein, wobei Durchkontakte für eine elektrische Kontaktierung der beiden Umverdrahtungen sorgen.

Die Erfindung ermöglicht eine vorteilhafte Vormontage des elektrischen Bauteils auf der Umverdrahtungsträgerschicht und ein elektrisches Prüfen des Insertstücks, d.h. insbesondere des elektrischen Bauteils und seiner Umverdrahtung, vor Einbau in den Schichtstapel. Dies gewährleistet, dass das Insertstück nur mit funktionsfähigen elektrischen Bauteilen bestückt wird und nur fehlerfrei bestückte und ordnungsgemäß arbeitende Insertstücke in den Mehrschichtaufbau eingebracht werden. Die Umverdrahtung ermöglicht eine Vergröberung von Anschlussstrukturen für die Kontaktierung des oder der Bauteile mit Leiterstrukturen des Schichtstapels oder nach außen, d.h. entsprechende Kontaktflächen können größer und/oder mit größerem Abstand voneinander angeordnet werden als die jeweils direkt am Bauteil vorhandenen Anschlusskontakte. Dies mindert die Anforderungen hinsichtlich Positioniergenauigkeit für einzubringende Sackloch- oder Durchkontakte. Da die Umverdrahtung auf dem Insertstück realisiert ist, braucht sie nicht auf einer der Leiterebenen des Schichtstapels erzeugt werden und das jeweilige elektrische Bauteil braucht nicht auf einer solchen Leiterstrukturebene an entsprechender Stelle hochgenau positioniert werden, was den Fertigungsaufwand verringert und die Funktionszuverlässigkeit erhöht.

Die Realisierung der Umverdrahtung auf dem in das Innere des Leiterplatten-Mehrschichtaufbaus integrierten Insertstück und speziell auf der Chipmontageseite der Umverdrahtungsschicht hat den weiteren Vorteil, dass sich der Platzbedarf auf der oder den Außenlagen des Mehrschichtaufbaus verringern lässt, da nur noch die entsprechenden Durchkontakte an die Oberfläche des Mehrschichtaufbaus zu führen sind. Zudem vereinfacht sich eine Entflechtung der Außenlagen, da die Position der Umverdrahtungskontaktstellen auf der Umverdrahtungsträgerschicht so gewählt werden kann, dass die zugehörigen Durchkontakte zu den Außenlagen an eine für die Entflechtung der Außenlagen günstigen Stelle platziert werden können.

Da das Insertstück bzw. deren Umverdrahtungsträgerschicht sich nur über einen lateralen Teilbereich des Schichtstapels erstreckt, werden Delaminationsprobleme verhindert, selbst wenn die Haftfähigkeit z.B. einer Umverdrahtungsträgerschicht aus Polyimid an einem Prepregmaterial der angrenzenden Unterlagenschicht nicht besonders hoch sein sollte.

Die Umverdrahtungsträgerschicht kann z.B. als flexible, dünne Schicht mit Interposer-Wirkung realisiert werden. Diese Maßnahme trägt dazu bei, mechanische Spannungen gering zu halten, die durch thermische Ausdehnungseffekte verursacht werden. Dies ist besonders dann von Bedeutung, wenn signifikante Temperaturänderungen des Schichtstapels im Betrieb oder bei der Weiterverarbeitung auftreten.

In einer vorteilhaften Weiterbildung der Erfindung nach Anspruch 9 besteht die Umverdrahtungsträgerschicht aus einem flexiblen Leiterplattenmaterial, wie einem Flüssigkristallpolymer(LCP)- oder Polyimidmaterial, oder einem Keramikmaterial und sie weist in einem mittleren Bereich einen Bauteilmontageplatz für das oder die zu montierenden elektrischen Bauteile und in einem peripheren Bereich Umverdrahtungskontaktstellen auf, die mit dem Bauteilmontageplatz über zugehörige Leiterbahnen elektrisch verbunden sind. Die mittige Bauteilplatzierung auf der Umverteilungsträgerschicht trägt ebenfalls zur Kompensation von thermischen Ausdehnungskräften bei, da sich auf diese Weise laterale Zug- und Druckkräfte weitestgehend aufheben. Die Umverdrahtung vom mittigen Bauteilmontageplatz zum peripheren Trägerschichtbereich leistet zudem eine Vergröberung der Anschlussstruktur des Bauteils, da im peripheren Bereich mehr Platz für Kontaktstellen zur Verfügung steht.

In einer Weiterbildung der Erfindung nach Anspruch 10 ist zwischen dem Insertstück einerseits und wenigstens einer der als Unterlagenschicht bzw. Deckschicht fungierenden, das Insertstück beidseitig abdeckenden Flüssigharz- oder Prepeg-Schichten ein jeweiliges Pufferschichtstück vorgesehen, wobei sich dieses Pufferschichtstück nur über eine laterale Teilfläche des Schichtstapels erstreckt, vorzugsweise allenfalls wenig größer als das Insertstück, und hinsichtlich Material und Schichtdicke z.B. so gewählt sein kann, dass es zwischen dem thermischen Ausdehnungskoeffizienten der Umverdrahtungsträgerschicht des Insertstücks und demjenigen der Unterlagenschicht bzw. Deckschicht vermittelt und/oder mechanische Spannungen aufnehmen kann und/oder in der Lage ist, Leiterstrukturen an einer dem Insertstück gegenüberliegenden Oberfläche der Unterlagenschicht bzw. der Deckschicht elektrisch gegenüber dem Insertstück zu isolieren.

In einer Weiterbildung der Erfindung nach Anspruch 11 ist auf der Umverdrahtungsträgerschicht in einem Bereich lateral außerhalb des oder der montierten elektrischen Bauteile eine Höhenabstandshalterstruktur vorgesehen, die sich in Stapelrichtung so weit wie das oder die montierten elektrischen Bauteile oder über diese hinaus erstreckt. Die Höhenabstandshalterstruktur kann dadurch das oder die montierten elektrischen Bauteile von beim Verpressen des Mehrschichtaufbaus einwirkenden Druckkräften entlasten.

In einer Weiterbildung der Erfindung nach Anspruch 12 beinhaltet das Insertstück zusätzlich eine Füll- und/oder Planarisierungsschicht, die sich ganzflächig oder nur im Bereich außerhalb des oder der elektrischen Bauteile über der Umverdrahtungsträgerschicht erstreckt. Diese ist in der Lage, bei Bedarf größere Höhenunterschiede des Insertstücks aufgrund des oder der aufgebrachten Bauteile auszugleichen bzw. laterale Freiräume aufzufüllen. Insbesondere ist diese Schicht bei Vorhandensein der Höhenabstandshalterstruktur auch in der Lage, Freiräume zwischen dieser Struktur und dem oder den montierten elektrischen Bauteilen auszufüllen.

In einer Ausgestaltung dieser Maßnahme besteht die Füll- und/oder Planarisierungsschicht gemäß Anspruch 13 aus einem thermisch leitfähigen, jedoch elektrisch isolierenden Material. Dies ermöglicht bei Bedarf eine Wärmeabführung von dem oder den elektrischen Bauteilen.

In einer weiteren Ausgestaltung der Maßnahme, eine Füll- und/oder Planarisierungsschicht aus thermisch leitfähigem Material vorzusehen, umfasst das Insertstück gemäß Anspruch 14 eine Wärmeleitschicht über der Füll- und/oder Planarisierungsschicht in Wärmekontakt zu derselben. Damit kann z.B. von dem oder den montierten elektrischen Bauteilen im Betrieb entwickelte Wärme effektiv über die Füll- und/oder die Planarisierungsschicht und die darüber liegende Wärmeleitschicht abgeführt bzw. verteilt werden.

In einer weiteren Ausgestaltung weist gemäß Anspruch 15 das Insertstück eine Deckschicht über der Füll- und/oder Planarisierungsschicht bzw. der Wärmeleitschicht auf, wobei die Deckschicht hinsichtlich Material und/oder Größe in lateraler Richtung und Stapelrichtung gleichartig zur Umverdrahtungsträgerschicht gewählt ist. Damit erhält das Insertstück einen vergleichsweise symmetrischen Schichtaufbau, was ebenfalls dazu beiträgt, mechanische Spannungen aufgrund von Ausdehnungseffekten gering zu halten und Biegebeanspruchungen zu minimieren.

In einer weiteren Ausgestaltung gemäß Anspruch 16 bzw. 17 ist die Wärmeleitschicht des Insertstücks und/oder wenigstens eine der Umverdrahtungskontaktstellen über einen oder mehrere Durchkontakte mit wenigstens einer wärmeleitfähigen, strukturierten oder ganzflächigen Schicht des Schichtstapels wärmeleitend verbunden, so dass Wärme vom Insertstück weg in den Schichtstapel verteilt und gegebenenfalls nach außen abgeführt werden kann.

In einer Weiterbildung der Erfindung nach Anspruch 18 sind die beiden das Insertstück abdeckenden Flüssigharz- oder Prepreg-Schichten in Stapelrichtung etwa mittig im Schichtstapel angeordnet, so dass dementsprechend auch das Insertstück in Stapelrichtung etwa mittig im Schichtstapel liegt.

Das erfindungsgemäße Verfahren ermöglicht eine Fertigung eines erfindungsgemäßen Leiterplatten-Mehrschichtaufbaus mit relativ geringem Aufwand, wobei eine komplette und spaltfreie Einbettung des Insertstücks in Harzmaterial realisiert werden kann.

Bei einem nach Anspruch 20 weitergebildeten Verfahren werden durch die Umverdrahtungsträgerschicht des Insertstücks hindurchführende Durchkontakte in vorteilhafter Weise so eingebracht, dass das elektrische Durchkontaktmaterial nicht mit dem Material der Umverdrahtungsträgerschicht in Kontakt ist, sondern mit einem zwischenliegenden Harzmaterial. Dies kann die Zuverlässigkeit der Durchkontakte verbessern.

In einer vorteilhaften Ausgestaltung werden Umverdrahtungsleiterbahnen gemäß Anspruch 21 durch Trenngrabenstrukturierung einer ganzflächig auf die Umverdrahtungsträgerschicht des Insertstücks aufgebrachten, elektrisch leitenden Umverdrahtungsschicht gebildet. Durch diese Maßnahme verbleibt der Großteil der ganzflächigen, vorzugsweise metallischen Umverdrahtungsschicht auf der Trägerschicht, was ebenfalls dazu beitragen kann, thermische Ausdehnungsprobleme zu mindern. Außerdem können auf der Umverdrahtungsschicht, die z.B. aus Cu besteht, relativ einfach haftvermittelnde Substanzen aufgebracht werden, wodurch sich die Haftung des Insertstücks im Gesamtverbund und speziell zu einer angrenzenden Prepreg-Deckschicht verbessern lässt.

Vorteilhafte Ausführungsformen der Erfindung sind in den Zeichnungen dargestellt und werden nachfolgend beschrieben. Hierbei zeigen:
- Fig. 1: eine schematische Draufsicht auf einen Teilbereich einer Unterlagenschicht eines Leiterplatten-Mehrschichtaufbaus mit aufgebrachtem Insertstück, das ein montiertes elektrisches Bauteil und eine zugehörige Umverdrahtung aufweist,
- Fig. 2: eine Schnittansicht längs einer Linie II-II von Fig. 1,
- Fig. 3: eine Längsschnittansicht eines Mehrschicht-Leiterplattenaufbaus in einem Teilbereich mit integriertem Insertstück nach Art der Fig. 1 und 2 und Sackloch-Durchkontakten,
- Fig. 3a: eine Längsschnittansicht entsprechend Fig. 3 für eine Variante mit rückseitig bewirkter Unterfüllung des auf dem Insertstück montierten elektrischen Bauteils,
- Fig. 3b: eine Längsschnittansicht entsprechend Fig. 3 für eine Variante mit beidseitig mit Bauteilen bestücktem Insertstück,
- Fig. 4: eine Längsschnittansicht analog zu Fig. 3 für eine Variante mit zusätzlichen Schichten und durchgehenden Durchkontakten,
- Fig. 5: eine Längsschnittansicht entsprechend Fig. 4 für eine Variante mit zusätzlicher Flüssigharz- oder Prepreg-Zwischenschicht mit Bauteilfenster,
- Fig. 6: eine Längsschnittansicht analog zu Fig. 2 für eine Insertstückvariante mit Höhenabstandshalterstruktur,
- Fig. 7: eine Längsschnittansicht entsprechend Fig. 4 für eine Variante mit integriertem Insertstück nach Art der Fig. 6,
- Fig. 8: eine Längsschnittansicht analog Fig. 7 für eine Variante mit die nicht zur Erfindung gehört mit hinsichtlich Wärmeableitung modifiziertem Insertstück und zusätzlicher Flüssigharz- oder Prepreg-Zwischenschicht und
- Fig. 9: eine Längsschnittansicht eines Mehrschicht-Leiterplattenaufbaus in einem Teilbereich mit integriertem Insertstück und darauf montiertem, in ein Innenlagen-Fenster hineinragendem elektrischem Bauteil.

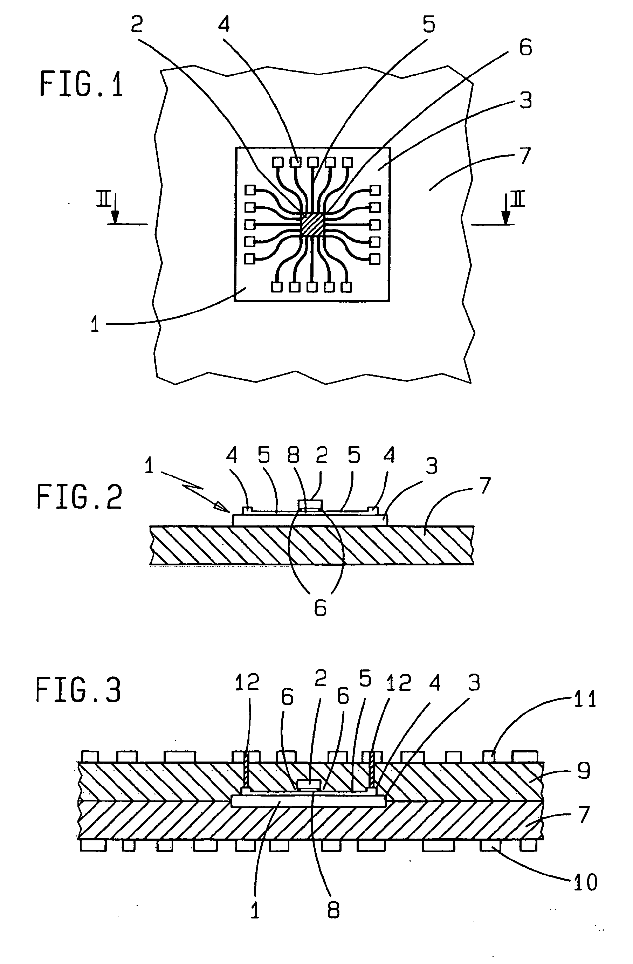

Die Fig. 1 und 2 veranschaulichen ein Insertstück 1, nachfolgend auch kurz als Insert bezeichnet, zur Integration eines aktiven elektrischen Bauteils 2, z.B. in Form eines Chips, in einen Leiterplatten-Mehrschichtaufbau. Das Insert 1 beinhaltet eine Umverdrahtungsträgerschicht 3 mit darauf aufgebrachter Umverdrahtung bestehend aus Umverdrahtungskontaktstellen 4 und Umverdrahtungsleiterbahnen 5 zur elektrischen Verbindung der Umverdrahtungskontaktstellen 4 mit je einer Anschlussableitung 6, d.h. Anschlussstelle, des Chips 2. Die Umverdrahtungsträgerschicht 3 besteht z.B. aus einem flexiblen Leiterplattenmaterial, wie einem LCP-Material oder einem Polyimidfolienmaterial mit einer Dicke von z.B. 25µm bis 50µm oder einem FR4-Material mit einer Dicke von z.B. 100µm. Alternativ ist auch ein übliches Keramikmaterial verwendbar. Allgemein sind für die Umverdrahtungsträgerschicht 3 solche Materialien von Vorteil, die in ihrem thermischen Ausdehnungskoeffizienten an das Material einer angrenzenden Schicht angepasst sind und/oder mechanische Spannungen absorbieren können, um mechanische Spannungsbelastungen für das Insert 1 möglichst gering zu halten.

Wie aus der Draufsicht von Fig. 1 ersichtlich, ist der Chip 2 auf einem zugehörigen Bauteilmontageplatz im Mittenbereich der Umverdrahtungsträgerschicht 3 und damit des Inserts 1 angebracht. Alternativ ist auch eine außermittige Chipmontage auf der Umverdrahtungsträgerschicht 3 möglich, die gezeigte mittige und damit bezüglich der lateralen Insertflächenausdehnung symmetrische Positionierung hat jedoch im allgemeinen Vorteile hinsichtlich Minimierung von Kraftbelastungen aufgrund mechanischer Spannungen bzw. thermischer Ausdehnungseffekte im Betriebseinsatz. Die Chipmontage kann durch eine beliebig herkömmliche Technik erfolgen, z.B. eine Flip-Chip-Montagetechnik, wie in Fig. 2 angedeutet, die dann vorzugsweise ein Unterfüllmaterial 8 im Zwischenraum zwischen Chip 2 und Umverteilungsträgerschicht beinhaltet. Die Fixierung des Chips 2 erfolgt mittels hierfür an sich bekannter Verbindungstechniken, z.B. durch Thermodenbonden, wie durch zugehörige Bondstellen an den Chipanschlüssen 6 repräsentiert.

Wie ebenfalls aus der Draufsicht von Fig. 1 zu erkennen, sind die Umverdrahtungskontaktstellen 4 in einem peripheren Bereich auf der Umverteilungsträgerschicht 3 angeordnet. Da in diesem gegenüber dem mittigen Bauteilmontageplatz deutlich flächengrößeren peripheren Bereich mehr Platz zur Verfügung steht, erfüllt die Umverdrahtung 4, 5 gleichzeitig eine Anschlussvergröberungsfunktion, d.h. die in ihrer Anzahl den Chipanschlussableitungen 6 entsprechenden Umverdrahtungskontaktstellen 4 können mit größerer Kontaktstellenausdehnung und/oder größerem Abstand voneinander angeordnet werden als die Chipanschlussableitungen 6, was die weitere Kontaktierung des Chips 2 über die Umverdrahtungskontaktstellen 4 zu anderen elektrisch leitenden Strukturen und/oder Bauteilen des Leiterplatten-Mehrschichtaufbaus und/oder aus letzterem heraus erleichtert. Die Umverdrahtungskontaktstellen 4 können in an sich bekannter Weise zusammen mit den Umverdrahtungsleiterbahnen 5 gefertigt werden.

Es versteht sich, dass in alternativen Ausführungsformen auch ein anderes aktives oder passives elektrisches Bauteil oder mehrere passive und/oder aktive elektrische Bauteile auf einer entsprechend modifizierten Insert-Umverdrahtungsträgerschicht an je einem zugehörigen Bauteilmontageplatz vorgesehen sein können. Dabei bedeutet der Begriff Bauteilmontageplatz lediglich, dass das betreffende elektrische Bauteil dort zu platzieren ist. Dies kann dadurch geschehen, dass das Bauteil separat vorgefertigt und dann an den Bauteilmontageplatz gebracht und dort fixiert wird, alternativ kann das Bauteil aber auch direkt am Bauteilmontageplatz z.B. als integrierte Halbleiterbauteilstruktur und/oder durch siebdrucktechnische bzw. photolithographische Prozesse gefertigt werden.

Im gezeigten Beispiel der Fig. 1 und 2 bestehen die Umverdrahtungsleiterbahnen 5 aus schmalen Leiterzügen, die durch einen der hierfür gängigen Prozesse auf der Umverdrahtungsträgerschicht 3 gebildet werden. In einer alternativen Ausführungsform sind die Leiterbahnen, welche die Chipanschlussstellen 6 mit den Umverdrahtungskontaktstellen 4 verbinden, durch breite, flächige Bereiche einer elektrisch leitenden Schicht gebildet, die ganzflächig auf die Umverdrahtungsträgerschicht 3 aufgebracht und dann durch einen Trenngrabenprozess in voneinander durch einen jeweiligen Trenngraben separierte Flächenbereiche aufgeteilt wird. Der Verlauf der Trenngräben ist so gewählt, dass jeder dieser Flächenbereiche eine der Chipanschlussstellen 6 und die zugehörige Umverdrahtungskontaktstelle 4 umfasst und dadurch deren zugehörige, verbindende, flächige Leiterbahn darstellt. Diese Ausführungsvariante hat den Vorteil, dass die gesamte chipseitige Oberseite der Umverdrahtungsträgerschicht 3 bis auf den Bereich des Chips 2 und der Trenngräben mit der Umverdrahtungsschicht, die z.B. aus Cu besteht, bedeckt bleibt, wodurch zum einen thermische Ausdehnungseffekte der Umverdrahtungsträgerschicht 3 abgeschwächt werden können und zum anderen bei Bedarf ein Haftvermittler auf die Umverdrahtungsschicht aufgebracht werden kann, um die Haftung einer nachfolgenden Schichtlage des Leiterplatten-Mehrschichtaufbaus zu verbessern und jegliche Delaminationsgefahr im Bereich des Inserts 1 zu unterbinden. Die Strukturierung der schmalen Leiterzüge 5 oder alternativ der flächigen Leiterbahnen erfolgt z.B. mittels gängiger Photolithographie- oder Laserstrukturierungsverfahren.

Von Vorteil ist die Wahl eines gut wärmeleitfähigen Materials, wie Cu, für die elektrisch leitende Umverdrahtungsschicht, da sie dann zusätzlich eine wärmeabführende bzw. wärmeverteilende Funktion erfüllen kann, um Überhitzungen im Bereich des aufgebrachten Chips 2 im Betriebseinsatz vorzubeugen.

In einer nicht gezeigten Ausführungsform ist eine elektromagnetische Abschirmung der Umverdrahtungsschicht bzw. der aus ihr gebildeten Umverdrahtung 4, 5 realisiert, indem über dieser und/oder zwischen dieser und der Umverdrahtungsträgerschicht 3 unter Zwischenfügung einer elektrisch isolierenden Schicht eine Abschirmschicht vorgesehen ist, z.B. in Form einer ganzflächigen, vorzugsweise metallischen Massepotentialschicht.

Das wie oben erläutert vorgefertigte Insertstück 1 wird dann zwecks Integration in einen Leiterplatten-Mehrschichtaufbau zunächst mit der Unterseite seiner Umverdrahtungsträgerschicht 3 auf einer Unterlagenschicht 7 an einer gewünschten Stelle in lateraler xy-Richtung koordinatengerecht fixiert. Die Fixierung kann z.B. mittels eines oder mehreren Klebepunkten oder einer flächigen Klebeverbindung oder mittels thermischer Beaufschlagung der Umverdrahtungsträgerschicht 3 selbst und/oder des mit dieser in Kontakt zu bringenden Bereichs der Unterlagenschicht 7 erfolgen. Die Unterlagenschicht 7 stellt eine ganzflächige, elektrisch isolierende dielektrische Schicht des zu fertigenden Leiterplatten-Mehrschichtaufbaus dar, die aus einem Prepregharzmaterial oder einem Flüssigharzmaterial besteht. Die genannte thermische Beaufschlagung führt dann zu einem partiellen Schmelzen, Kleben und Härten der Prepreg-Unterlagenschicht 7 im Bereich des aufgelegten Insertstücks 1, wodurch dieses fixiert wird.

Je nach Anwendungsfall kann die Unterlagenschicht 7 eine äußere oder innere Schicht des aus mehreren Schichten zu bildenden Schichtstapels des jeweils gewünschten Leiterplatten-Mehrschichtaufbaus sein. In letzterem Fall befinden sich eine oder mehrere weitere Schichtlagen an der dem Insertstück 1 abgewandten Seite der Unterlagenschicht 7, wobei die Unterlagenschicht 7 mit dem darauf fixierten Insertstück 1 auf diese eine oder mehreren weiteren Schichtlagen aufgelegt oder alternativ zunächst die Unterlagenschicht 7 allein auf diese eine oder mehreren weiteren Schichtlagen aufgelegt und dann darauf das Insertstück 1 fixiert wird.

Die weitere Fertigung des Leiterplatten-Mehrschichtaufbaus beinhaltet das Aufbringen einer ganzflächigen Deckschicht auf die mit dem angebrachten Insertstück 1 versehene Seite der Unterlagenschicht 7 unter Bedeckung des Insertstücks 1, so dass letzteres zwischen der Unterlagenschicht 7 und der Decklagenschicht im Inneren des Schichtstapels des Leiterplatten-Mehrschichtaufbaus liegt. Auf die Decklagenschicht werden, wenn selbige keine äußere Schichtlage des Leiterplatten-Mehrschichtaufbaus darstellt, eine oder mehrere weitere Schichtlagen aufgelegt, und nach Aufeinanderlegen aller für den Schichtstapel vorgesehenen Schichtlagen wird der Schichtstapel als Schichtpaket in einer üblichen Weise zur Bildung des gewünschten Leiterplatten-Mehrschichtaufbaus verpresst bzw. zusammenlaminiert.

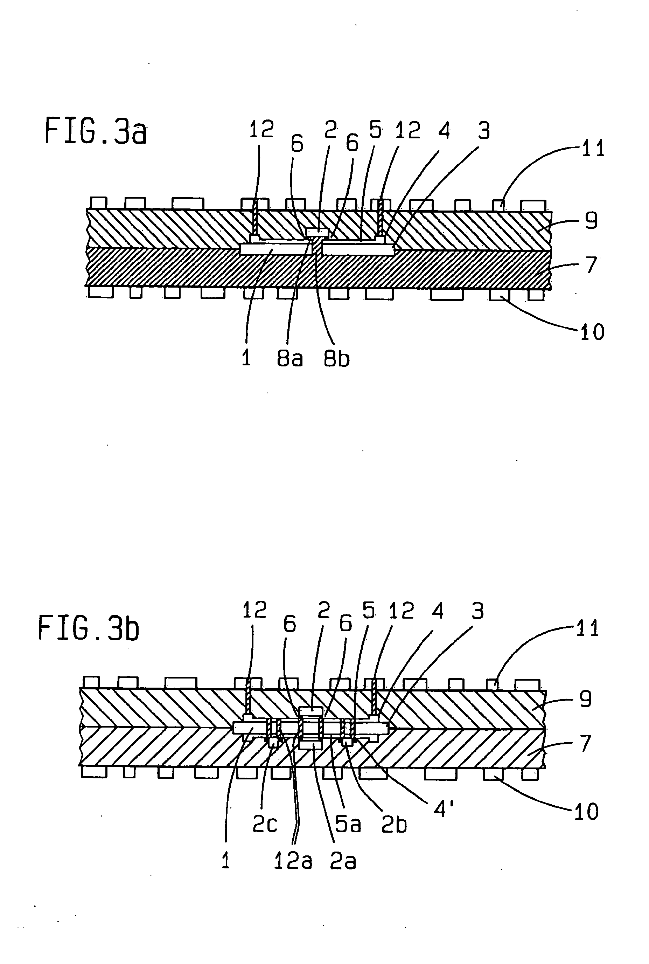

Unter Bezugnahme auf die Fig. 3 bis 7 und 9 werden nachfolgend einige spezielle Beispiele für die erfindungsgemäße Integration solcher und ähnlicher, mit einem oder mehreren aktiven und/oder passiven elektrischen Bauteilen bestückter Insertstücke in das Innere eines Leiterplatten-Mehrschichtaufbaus näher erläutert. Dabei sind der Übersichtlichkeit halber und zum besseren Verständnis nicht nur identische Elemente, sondern auch in ihrer Funktion äquivalente Elemente der verschiedenen Ausführungsbeispiele in den Fig. 1 bis 9 mit jeweils gleichen Bezugszeichen markiert.

Fig. 3 zeigt einen im Wesentlichen zweilagigen Leiterplattenaufbau mit zwei Außenlagen 7, 9 ohne Innenlage, wobei ausgehend vom Aufbau der Fig. 1 und 2 die dielektrische Unterlagenschicht 7 eine erste Außenlage und eine auf diese und das zwischengefügte Insert 1 aufgebrachte Deckschicht 9 eine zweite Außenlage bildet. Die Unterlagenschicht 7 und die Deckschicht 9 sind außenseitig jeweils mit einer elektrischen Leiterstrukturebene 10, 11, d.h. einer strukturierten elektrischen Leiterebene, üblicher Art versehen und bestehen vorzugsweise aus einem Prepregharzmaterial. Das Insertstück 1 mit seiner Umverdrahtungsträgerschicht 3, dem darauf montierten Chip 2 und der zugehörigen Umverdrahtung 4, 5 ist spalt- und hohlraumfrei zwischen der Unterlagenschicht 7 und der Deckschicht 9 in deren Harzmaterial eingebettet. Nach außen ist der Chip 2 über die Umverdrahtung 4, 5 und Sacklochkontakte 12 an Strukturelemente der Leiterebene 11 auf der Deckschicht 9 ankontaktiert, wobei die Durchkontakte 12 jeweils eine der Umverdrahtungskontaktstellen 4 mit dem zugehörigen Strukturelement der Leiterebene 11 durch die dielektrische Deckschicht 9 hindurch verbinden.

Zur Herstellung des Leiterplatten-Mehrschichtaufbaus von Fig. 3 wird zunächst, wie oben zu den Fig. 1 und 2 erläutert, das Insertstück 1 vorgefertigt und an der gewünschten Stelle auf der Prepregunterlage 7 fixiert. Anschließend wird die Prepregdeckschicht 9 auf die Prepregunterlage 7 mit dem darauf fixierten Insert 1 aufgelegt. Als Ausgangsmaterial dieses Aufbaus können für die beiden Schichten 7, 9 z.B. Prepregschichten verwendet werden, die mit aufgelegten Kupferfolien versehen werden, welche anschließend zur Bildung der Leiterstrukturebenen 10, 11 strukturiert werden.

Anschließend wird das gebildete Schichtpaket in üblicher Weise zum Schichtstapel-Gesamtverbund zwecks Fertigstellung des gewünschten Leiterplatten-Mehrschichtaufbaus verpresst bzw. zusammenlaminiert. Das Insertstück 1 wird dadurch spalt- und hohlraumfrei in durch den Pressdruck aufschmelzendes Harzmaterial eingebettet bzw. unter entsprechendem Eindrücken der Prepregunterlage 7 und der Prepregdecklage 9 zwischen diesen aufgenommen. Da in diesem Ausführungsbeispiel die Höhe des Insertstücks 1 einschließlich dem darauf montierten Bauteil 2 relativ gering ist, insbesondere viel kleiner als die Schichtdicke der angrenzenden Flüssigharz- oder Prepregschichten 7, 9, ergibt sich durch das Einbetten des Insertstücks keine merkliche Aufwölbung der abdeckenden Flüssigharz- oder Prepregschichten 7, 9. Alternativ kann in der Unterlagenschicht 7 und/oder in der Deckschicht 9 eine Ausnehmung im Bereich des Insertstücks 1 oder wenigstens des auf ihm montierten Bauteils 2 vorgesehen sein, um entsprechend Platz zum Aufnehmen des Insertstücks 1 bzw. des Bauteils 2 zu schaffen. Die Strukturierung der äußeren Leiterebenen 10, 11 wird nach diesem Press-/Laminiervorgang durchgeführt, z.B. durch einen herkömmlichen Lithographie- oder Laserstrukturierungsprozess.

Fig. 3a zeigt eine Variante des Ausführungsbeispiels von Fig. 3, bei der eine rück- bzw. unterseitige Verfüllung des in Flip-Chip-Technik montierten Chips 2 vorgesehen ist, der über die Chipanschlussstellen 6 erhaben über der Umverdrahtungsträgerschicht 3 sitzt. In dem Zwischenraum zwischen dem Chip 2 und der Umverdrahtungsträgerschicht 3 bzw. der Umverdrahtung 4, 5 befindet sich in diesem Beispiel ein Unterfüllmaterial 8a, das von unten über eine entsprechend in das Insertstück 1 eingebrachte Unterfüllöffnung 8b eingebracht wird. Dabei handelt es sich vorteilhafterweise um Harzmaterial, das sich beim Verpressen oder Laminieren des Aufbaus in der Unterlagenschicht 7 verflüssigt und durch die Unterfüllöffnung 8b nach oben gedrückt wird und den dortigen Zwischenraum zwischen dem Chip 2 und dem darunter liegenden Teil der Umverdrahtungsträgerschicht 3 bzw. der Umverdrahtung 4, 5 hohlraumfrei ausfüllt. Im Übrigen entspricht das Ausführungsbeispiel von Fig. 3a demjenigen von Fig. 3. Insbesondere wird durch das Unterfüllen die Bildung von Lufteinschlüssen vermieden, die zu Delaminationseffekten führen könnten.

Fig. 3b zeigt eine Variante des Ausführungsbeispiels von Fig. 3, bei der das zwischen die Unterlagenschicht 7 und die Deckschicht 9 hohlraumfrei in Harzmaterial eingebettete Insertstück 1 beidseitig mit Bauteilen bestückt ist. Exemplarisch sind außer dem auf der Oberseite montierten Chip 2 unterseitig montierte Bauteile gezeigt, speziell z.B. ein weiterer Chip 2a, ein elektrischer Widerstand 2b und ein Kondensatorelement 2c oder andere aktive oder passive elektrische Bauteile. Die unterseitig montierten elektrischen Bauteile 2a, 2b, 2c sind an eine rückseitige Umverdrahtung mit Kontaktstellen 4' und Umverdrahtungsleiterbahnen 5a angekoppelt, und die rückseitige Umverdrahtung 4', 5a ist über Durchkontakte 12a, die sich durch das Insertstück 1 hindurch erstrecken, mit der oberseitigen Umverdrahtung 4, 5 elektrisch verbunden. Im Übrigen entspricht diese Variante wiederum dem Ausführungsbeispiel von Fig. 3, so dass auf die diesbezüglichen obigen Ausführungen verwiesen werden kann.

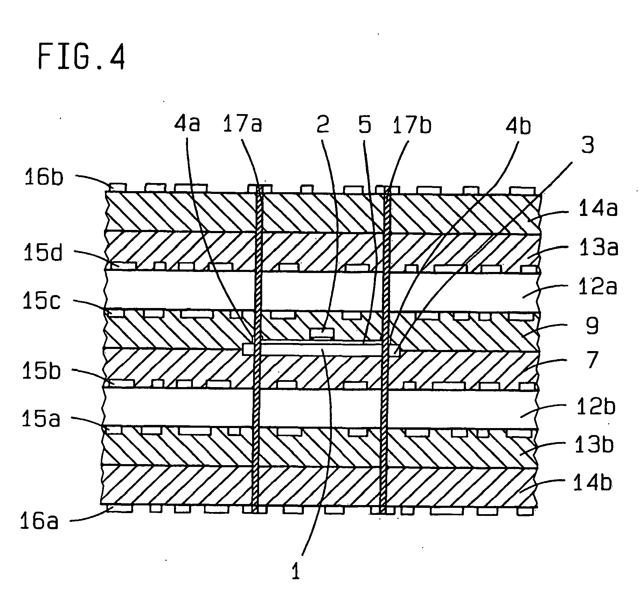

Fig. 4 zeigt eine weitere Variante der Integration des Insertstücks 1 in das Innere eines Leiterplatten-Mehrschichtaufbaus, der im Vergleich zum Leiterplattenaufbau von Fig. 3 zusätzliche Innenlagen 12a, 12b aufweist. Speziell ist das Insertstück 1 im Beispiel von Fig. 4 wie im Fall von Fig. 3 zwischen die Unterlagenschicht 7 und die Deckschicht 9 eingebettet, die jedoch hier innere dielektrische Schichten des Leiterplatten-Mehrschichtaufbaus bilden. Beidseits schließen sich an diese je eine Innenlage in Form einer vorgefertigten Halberzeugnisleiterplatte 12a, 12b und je zwei weitere Prepreg-Schichtlagen 13a, 13b bzw. 14a, 14b zur Vervollständigung des zugehörigen Schichtstapels an. Beidseits jeder der beiden Halberzeugnisleiterplatten 12a, 12b ist je eine innere Leiterstrukturebene 15a bis 15d ausgebildet und in das Harzmaterial der angrenzenden Prepregschichtlage eingebettet. Die beiden äußeren Prepregschichtlagen 14a, 14b tragen außenseitig je eine äußere Leiterstrukturebene 16a, 16b. Zum Herstellen der äußeren Leiterstrukturebenen 16a, 16b ist es z.B. üblich, kupferkaschiertes dielektrisches Schichtmaterial für die Außenlagen 14a, 14b zu verwenden und die außenliegende, ganzflächige Kupferschichtlage nach dem Verpressen des Schichtstapels mittels üblicher Techniken zu strukturieren.

Zur Herstellung des Aufbaus von Fig. 4 werden zunächst die unteren Schichtlagen bis einschließlich der Unterlagenschicht 7 übereinandergelegt und das Insertstück 1 auf der Unterlagenschicht 7 fixiert. Dann wird die Deckschicht 9 aufgelegt. Anschließend werden die weiteren Schichtlagen zur Bildung eines entsprechenden Schichtpakets aufgelegt, das dann zusammenlaminiert bzw. verpresst wird, wodurch auch das Insertstück 1 in die Harzmasse zwischen der Prepregunterlage 7 und der Prepregdecklage 9 sicher eingebettet wird.

Nach der Herstellung des verpressten Schichtstapel-Gesamtverbunds erfolgt in üblicher Weise die Kontaktierung der verschiedenen Leiterstrukturebenen 15a bis 16b sowie des Chips 2 auf dem Insertstück 1 durch Einbringen entsprechender Durchkontakte. Beispielhaft sind in der Schnittansicht von Fig. 4 zwei sich zwischen zugehörigen Strukturelementen der beiden äußeren Leiterstrukturebenen 16a, 16b durch den gesamten Schichtstapel hindurch erstreckende Durchkontakte 17a, 17b zu erkennen, die gleichzeitig zugehörige Umverdrahtungskontaktstellen 4a, 4b kontaktieren und dementsprechend eine elektrische Verbindung zugehöriger Anschlüsse des Chips 2 nach außen herstellen, z.B. zur Spannungsversorgungs- oder Masseanbindung. Die Durchkontakte 17a, 17b werden in einer herkömmlichen Technik durch Einbringen entsprechender Durchkontaktlöcher und Einbringen von elektrisch leitfähigem Material in selbige z.B. durch Plattieren erzeugt, wobei im gleichen Arbeitsgang bei Bedarf auch eine Dickenerhöhung der äußeren Leiterstrukturen 16a, 16b erfolgen kann. Alternativ kann die Kontaktierung des Chips 2 nach außen über die Umverdrahtungskontaktstellen auch durch Einbringen von bis zu den Umverdrahtungskontaktstellen reichenden Sacklochkontakten erfolgen.

Somit zeigt Fig. 4 eine Ausführungsform, bei der sich die Unterlagenschicht 7 und die Deckschicht 9 und folglich auch das zwischen diesen eingebettete Insert 1 mit dem darauf montierten Chip 2 in Stapelrichtung gesehen mittig im Leiterplattenschichtstapel befinden.

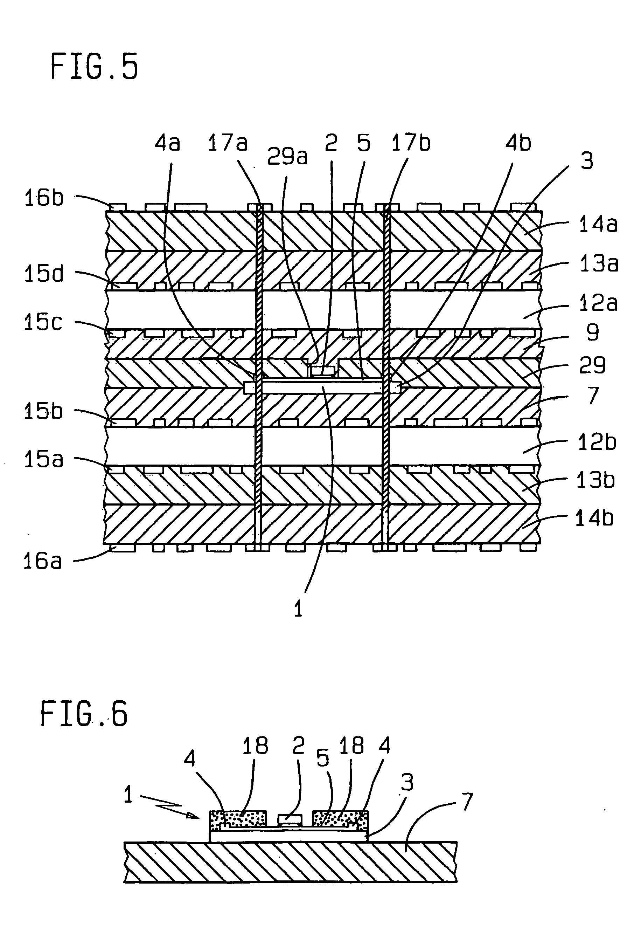

Fig. 5 veranschaulicht eine Variante des Ausführungsbeispiels von Fig. 4, bei der als einziger signifikanter Unterschied eine zusätzliche Flüssigharz- oder Prepreg-Zwischenschicht 29 im Stapelschichtaufbau zwischen der Unterlagenschicht 7 und der Deckschicht 9 vorgesehen ist. Wie gezeigt, ist diese Zwischenschicht 29 im Bereich des auf dem Insertstück 1 montierten elektrischen Bauteils 2 mit einem Fensterbereich 29a versehen, in den das Bauteil 2 hineinragt. Beim Verpressen oder

Laminieren des Aufbaus verflüssigt sich auch das Harzmaterial der Flüssigharz- oder Prepreg-Zwischenschicht 29 und trägt zur kompletten spaltfreien Umschließung des Insertstücks 1 samt montiertem Bauteil 2 bei. Die Zwischenschicht 29 mit dem Fenster 29a sorgt für Aufnahmeraum des auf dem Insertstück 1 montierten Chips 2 und erleichtert so das homogene spaltfreie Einbetten des Insertstücks zwischen die beiden unten bzw. oben abdeckenden Flüssigharz- oder Prepreg-Schichten 7, 9, ohne dass sich letztere dabei im Bereich des Insertstücks 1 merklich wölben. Außerdem sorgt die Zwischenschicht 29 für eine Entlastung des Chips 2 vor den beim Verpressen bzw. Laminieren einwirkenden mechanischen Druckbelastungen, was besonders für relativ dünne, druckempfindliche Chips von Vorteil ist.

Es versteht sich, dass die Zwischenschicht 29 auch eine Schichtlage einer mehrlagigen Deckschicht bestehend aus der Decklage 9 und der Zwischenschichtlage 29 darstellen kann, wobei dann in dieser mehrlagigen Deckschicht wenigstens die Zwischenschicht 29, die auf der dem Insertstück 1 zugewandten Seite dieser mehrlagigen Deckschicht liegt, mit dem Fenster 29a versehen ist. Alternativ kann sich das Fenster 29a bei Bedarf auch über den gesamten Bereich des Insertstücks 1 erstrecken, wenn für letzteres insgesamt zusätzlicher Aufnahmeraum benötigt wird.

Fig. 6 zeigt eine Variante hinsichtlich der Gestaltung des Insertstücks 1. Ausgehend vom Beispiel der Fig. 1 bis 4 weist das Insertstück 1 von Fig. 5 zusätzlich eine strukturierte Höhenabstandshalterschicht 18 über der Umverdrahtungsträgerschicht 3 und der Umverdrahtung 4, 5 im Bereich außerhalb des montierten Chips 2 und mit etwas lateralem Abstand von diesem auf. Das Aufbringen der Höhenabstandshalterschicht 18 kann je nach Bedarf vor oder nach dem Platzieren des Inserts 1 auf der Unterlagenschicht 7 erfolgen. Die Höhenabstandshalterschicht 18 erstreckt sich von der Umverdrahtungsträgerschicht 3 bzw. der Umverdrahtung 4, 5 aus bis mindestens zur Oberseite des montierten Chips 2, im Beispiel von Fig. 5 wie gezeigt etwas darüber hinaus. Auf diese Weise ist die Höhenabstandshalterschicht 18 in der Lage, den Chip 2 von übermäßigen Druckbelastungen beim Verpressen des vorbereiteten Schichtstapels, in dessen Inneres das Insert 1 integriert wird, zu entlasten. Als Material für die z.B. siebdrucktechnisch erzeugbare, strukturierte Höhenabstandshalterschicht 18 ist beispielsweise ein Epoxidharzmaterial verwendbar. Optional kann in der Höhenabstandshalterschicht 18 eine Freisparung im Bereich der Kontaktstellen 4 vorgesehen sein, die in an sich herkömmlicher Weise erzeugt werden kann, um spätere Durchkontaktierungsprobleme zu vermeiden bzw. die Haltbarkeit der Druckkontaktierung, z.B. eine Kupferhülse, zu verbessern.

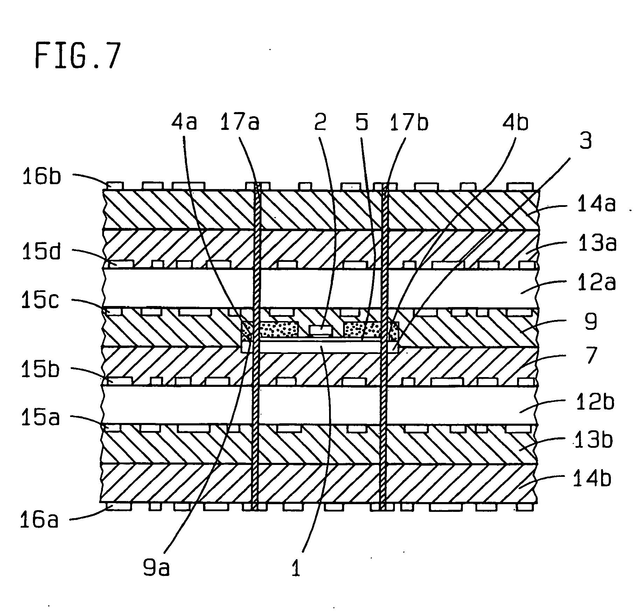

Fig. 7 veranschaulicht die Integration eines Insertstücks der in Fig. 6 gezeigten Art in einen Leiterplatten-Mehrschichtaufbau, der im Übrigen demjenigen von Fig. 4 entspricht, so dass auf deren obige Beschreibung verwiesen werden kann. Zur leichteren Aufnahme des in diesem Fall etwas dickeren Insertstücks ist die Deckschicht 9 mit einer passenden Ausnehmung 9a versehen. Alternativ oder zusätzlich kann eine entsprechende Ausnehmung in der Unterlagenschicht 7 vorgesehen sein.

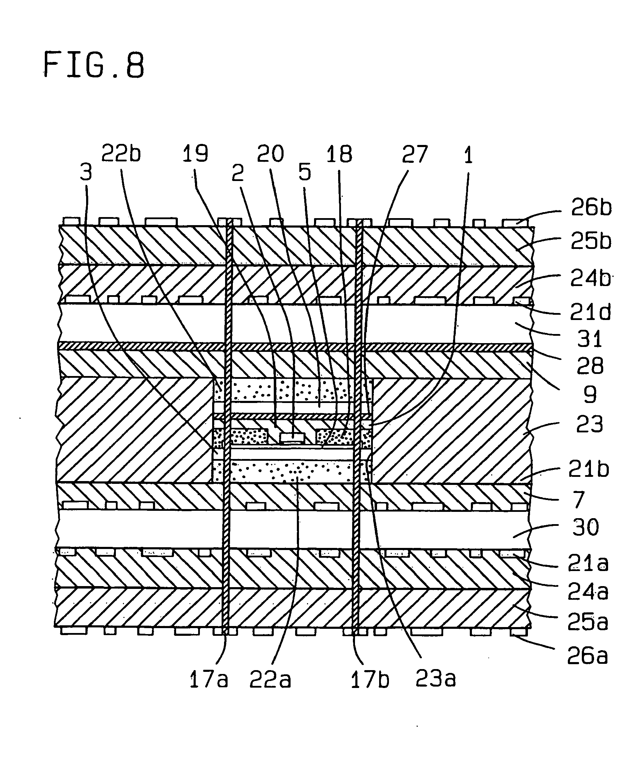

Fig. 8 veranschaulicht die Integration des Insertstücks 1 gemäß Fig. 6 in einem weiteren Beispiel. Im Beispiel der Fig. 8 beinhaltet das Insertstück 1 ausgehend vom Aufbau gemäß Fig. 6 des weiteren eine Füll-/Planarisierungsschicht 19, welche sich ganzflächig und mit im Wesentlichen planer Oberseite über der Höhenabstandshalterschicht 18 und dem Chip 2 erstreckt und dabei auch den lateralen Freiraum zwischen dem Chip 2 und der strukturierten Höhenabstandshalterschicht 18 ausfüllt. Bei Bedarf kann es von Vorteil sein, für die Füll-/Planarisierungsschicht 19 ein thermisch leitfähiges Material zu verwenden, um Wärme vom Bereich des Chips 2 abführen bzw. verteilen zu können.

Auf die Füll-/Planarisierungsschicht 19 ist eine Insertdeckschicht 20 ganzflächig aufgebracht, die in Material und Dicke identisch zur Umverdrahtungsträgerschicht 3 ist oder alternativ dieser jedenfalls weitgehend in der Dicke und im thermischen Ausdehnungsverhalten entspricht. So kann die Insertdeckschicht 20 z.B. wie die Umverdrahtungsträgerschicht 3 aus einem Polyimidmaterial oder einem Keramikmaterial bestehen. Diese Auslegung der das Insert 1 oben abschließenden Deckschicht 20 in Anpassung an die das Insert 1 unten abschließende Umverdrahtungsträgerschicht 3 resultiert in einem relativ symmetrischen Schichtaufbau des Inserts 1, was die Funktionszuverlässigkeit und Robustheit des Inserts 1 gegenüber thermischen Belastungen während der weiteren Fertigung des Leiterplatten-Mehrschichtaufbaus und im späteren Betrieb und gegenüber dadurch verursachten mechanischen Spannungsbelastungen steigern kann.

Im Beispiel von Fig. 8 sitzt das Insertstück 1 auf einem Pufferschichtstück 22a auf, das aus einem Material gebildet ist, das mechanische Spannungen, insbesondere aufgrund thermischer Belastungen, ausgleichen bzw. zwischen den thermischen Ausdehnungskoeffizienten der oberseitig angrenzenden Umverdrahtungsträgerschicht 3 des Inserts 1 und einer unterseitig angrenzenden elektrisch leitenden Schicht vermitteln kann. Beispielsweise kann das Pufferschichtstück aus einem Epoxidharzmaterial bestehen. Das Pufferschichtstück 22a liegt in diesem Beispiel auf der Unterlagenschicht 7 auf, die ihrerseits auf einer beidseitig mit Leiterbahnstrukturen versehenen Innenlage 30 liegt. Das Pufferschichtstück 22a kann z.B. siebdrucktechnisch erzeugt oder aus einem entsprechenden Schichtmaterial ausgeschnitten und an der betreffenden Stelle auf die Unterlagenschicht 7 aufgelegt und fixiert werden. Auf dem Pufferschichtstück 22a wird dann während der Herstellung des Leiterplatten-Mehrschichtaufbaus von Fig. 8 das Insertstück 1 mit dem geschilderten Aufbau fixiert. Weiter beinhaltet der Schichtaufbau von Fig. 8 über der Unterlagenschicht 7 eine Flüssigharz- oder Prepreg-Zwischenschicht 23 mit einem Fensterbereich 23a, in welchem das Insertstück 1 samt Pufferschichtstück 22a aufgenommen ist. Das Fenster 23a ist in diesem Beispiel in der Größe des Pufferschichtstücks 22a, dessen laterale Abmessung derjenigen des Insertstücks entspricht, ausgeschnitten oder ausgefräst, und der laterale Zwischenraum zum Insertstück 1 füllt sich dann beim späteren Verpressen mit aufgeschmolzenem bzw. fließfähigem Harzmaterial. Dies ermöglicht wiederum das homogene Einbetten des Insertstücks 1, das in diesem Fall zusammen mit dem Pufferschichtstück 22a eine merkliche Höhe besitzt, in den Schichtstapelaufbau bei gleichzeitig spaltfreiem Umschließen mit Harzmaterial aus der Unterlagenschicht 7a, der Deckschicht 9a und der Zwischenschicht 23, ohne dass sich die Unterlagenschicht 7 und die Deckschicht 9 im Bereich des Insertstücks 1 unerwünschterweise wölben.

Wie oben zum Pufferschichtstück 22a erläutert, kann es von Vorteil sein, ein entsprechendes Pufferschichtstück 22b als Teil des Inserts 1 zwischen diesem und der Deckschicht 9 vorzusehen, um thermische bzw. mechanische Belastungen auszugleichen, wie ebenfalls in Fig. 8 dargestellt. Außerdem ergibt sich durch die symmetrische Anordnung des oberen Pufferschichtstücks 22b zum unteren Pufferschichtstück 22a, wobei vorzugsweise im Wesentlichen gleiche Schichtdicken und gleiche oder hinsichtlich thermischem Ausdehnungsverhalten ähnliche Materialien verwendet werden, ein weiterer Beitrag zur Minimierung der Kraftbelastungen für das Insert 1 mit seinem Chip 2. Des weiteren ist auch der Leiterplatten-Mehrschichtaufbau von Fig. 6 insgesamt wiederum von bezüglich einer Stapelmittenebene weitgehend symmetrischer Natur, und das Insert 1 mit dem Chip 2 liegt in Stapelrichtung gesehen im Mittenbereich des Mehrschichtaufbaus.

Es versteht sich analog zur Zwischenschicht 29 von Fig. 5, dass die Zwischenschicht 23 auch einen Teil einer mehrlagigen Realisierung der Unterlagenschicht 7 oder einer mehrlagigen Realisierung der Deckschicht 9 darstellen kann. Weiter versteht sich, dass in diesem und allen anderen gezeigten und beschriebenen Ausführungsbeispielen jede der einheitlich dargestellten Flüssigharz- oder Prepreg-Schichten, die als Unterlagenschicht und Deckschicht zum beidseitigen Abdecken des Insertstücks fungieren, d.h. in diesem Beispiel die Schichten 7 und 9, und/oder die dazwischenliegende Zwischenschicht, d.h. in diesem Beispiel die Zwischenschicht 23, jeweils mehrlagig mit wenigstens 2 Flüssigharz- oder Prepreg-Schichtenlagen aufgebaut sein können.

Das Beispiel gemäß Fig. 8 weist außer der unteren Innenlage bzw. Halberzeugnisleiterplatte 30 auch eine obere Innenlage bzw. obere Halberzeugnisleiterplatte 31 mit obenliegender Leiterstrukturebende 21 d auf. Es folgen nach unten bzw. oben jeweils eine weitere Prepreglage 24a, 24b und eine äußere dielektrische Schichtlage 25a, 25b. Die äußeren Dielektrikumschichtlagen 25a, 25b tragen außenseitig je eine äußere Leiterstrukturebene 26a, 26b, wozu sie aus einem Prepregmaterial und einer aufliegenden Kupferfolie bestehen können. Durch das Verpressen des Schichtpakets wird die Kupferfolie fest mit dem Prepregmaterial verbunden und die dadurch gebildete Kupferschicht wird im Wege gängiger Prozessschritte in die entsprechende Leiterstrukturebene 26a, 26b strukturiert.

Zur Bereitstellung einer gesteigerten Wärmeableitungsfunktion sind bei dem Beispiel von Fig_{.} 8 zusätzliche Wärmeabführungsmaßnahmen vorgesehen. Dazu weist das Insertstück 1 eine hoch wärmeleitfähige Schicht 27, z.B. aus Cu, zwischen der Füll-/Planarisierungsschicht 19 und der Insertdeckschicht 20 auf. Außerdem ist eine innere Leiterstrukturebene der oberen Halberzeugnisleiterplatte 31 durch eine unstrukturiert bleibende, ganzflächige Wärmeleitschicht 28 ersetzt, bei der es sich z.B. einfach um eine unstrukturiert bleibende Kupferbeschichtung dieser Halberzeugnisleiterplatte 9a handeln kann.

Wie aus einem Vergleich der Fig. 4 und 8 ersichtlich, entspricht der Schichtstapel von Fig. 8 in seinem Aufbau abgesehen von der Modifikation hinsichtlich der unstrukturierten Wärmeleitschicht 28 und der Zwischenschicht 23 sowie der modifizierten Gestaltung und Einbettung des Insertstücks 1 demjenigen von Fig. 4. Wie daraus weiter ersichtlich, wird der Leiterplatten-Mehrschichtaufbau von Fig. 8 in analoger Weise durch Einbringen der erforderlichen Durchkontakte fertiggestellt, wobei beispielhaft die beiden Durchkontakte 17a, 17b entsprechend dem Beispiel von Fig. 4 gezeigt sind.

Im Beispiel von Fig. 8 erfüllen diese Durchkontakte 17a, 17b zusätzlich eine Wärmetransportfunktion, indem sie aus einem gut wärmeleitfähigen Material, z.B. Cu, gebildet sind. Denn über die Durchkontakte 17a, 17b stehen die zugehörigen Umverdrahtungskontaktstellen und vor allem auch die Wärmeleitschicht 27 des Inserts 1 mit der ganzflächigen Wärmeleitschicht 28 des Schichtstapels in wärmeleitender Verbindung, so dass sehr effektiv Wärme, die im Bereich des Chips 2 entsteht, über die Umverdrahtung 4, 5 einerseits sowie die Füll-/Planarisierungsschicht 19 und die Insert-Wärmeleitschicht 27 andererseits zu den Durchkontakten 17a, 17b geleitet und über diese zur ganzflächigen wärmeleitenden Schicht 28 abgeführt und von dieser verteilt werden kann. Diese Wärmeabführungsmaßnahme kann die Funktionszuverlässigkeit des auf dem eingebetteten Insert 1 montierten Chips 2 und der übrigen Insertkomponenten deutlich steigern, insbesondere in Fällen, in denen eine merkliche Wärmeentwicklung von Komponenten des Inserts 1 im Betrieb verursacht wird. Es versteht sich, dass sich zur wärmeleitenden Anbindung an die Wärmeleitschicht 28 des Schichtstapels jeweils potentialgleiche Durchkontakte eignen, wie gemeinsame Masse- oder Spannungsversorgungs-Durchkontakte.

Die Insert-Wärmeleitschicht 27 kann z.B. eine bereits auf der Insertdeckschicht 20 aus Polyimid oder dergleichen vorgefertigt vorhandene Schicht beispielsweise aus Kupfer sein. In diesem Fall kann die Insertdeckschicht 20 zusammen mit der wärmeleitenden Beschichtung 27 von einem großflächigeren Schichtmaterial ausgeschnitten und mit der Beschichtung 27 auf die Füll-/Planarisierungsschicht 19 aufgelegt werden. Dies kann je nach Bedarf vor dem Positionieren des Inserts 1 auf der Unterlagenschicht 7 oder danach erfolgen.

Auf Wunsch kann vorgesehen sein, die Durchkontakte 17a, 17b ohne Berührung zum Material der Umverdrahtungsträgerschicht 3, z.B. Polyimid, durch selbige hindurchzuführen. Dazu werden dann Bohrungen in die Umverdrahtungsträgerschicht 3 vor dem Einbetten des Insertstücks 1 zwischen die Unterlagenschicht 7 und die Deckschicht 9 mit gegenüber den späteren Durchkontakten größerem Durchmesser eingebracht. Beim Verpressen des Schichtstapels füllen sich diese Bohrungen mit hineinfließendem Harzmaterial aus der angrenzenden Harzschichtlage. Die nach dem Verpressen des Schichtstapels durch diesen hindurch eingebrachten Durchkontaktlöcher kleineren Durchmessers können dann auf Höhe der Umverdrahtungsträgerschicht 3 vollständig innerhalb der Harzfüllung verlaufen, so dass zwischen dem eingebrachten Durchkontaktmaterial und dem Material der Umverdrahtungsträgerschicht 3 ein isolierender Harzmaterialring verbleibt.

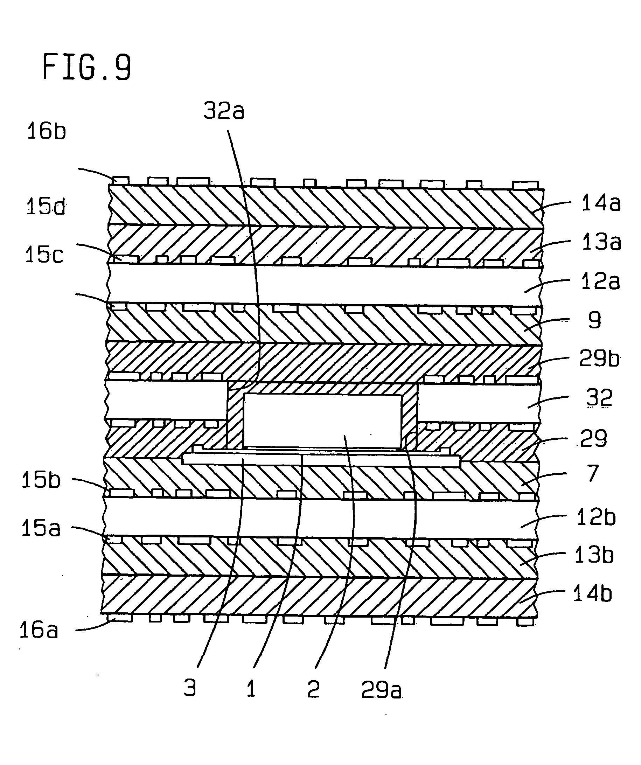

Fig. 9 zeigt als weiteres Ausführungsbeispiel der Erfindung eine Variante des Beispiels von Fig. 5, bei der als einzigem signifikantem Unterschied zum Aufnehmen des Insertstücks 1, auf dem in diesem Beispiel ein vergleichsweise dicker, z.B. gehäuster Chip 2 oder ein anderes gehäustes oder aus anderen Gründen relativ dickes elektrisches Bauteil montiert ist, ein Fensterbereich 32a zusätzlich in einer Innenlage 32 vorgesehen ist. Speziell befindet sich diese Innenlage 32 im Inneren einer mehrlagigen Zwischenschicht zwischen der Unterlagenschicht 7, auf der das Insertstück 1 aufliegt, und der Decklagenschicht 9. Die Zwischenschicht beinhaltet hierbei die Flüssigharz- oder Prepreg-Zwischenschicht 29 als untere Schichtlage, die Innenlage 32 als mittlere Schichtlage und eine obere Flüssigharz- oder Prepreg-Schichtlage 29b. Das Fenster 29a der unteren Zwischenschicht 29 und das Fenster 32a der Innenlage 32 bilden zusammen einen Aufnahmeraum. Die obere Zwischenschichtlage 29b sorgt für die obere Harzbedeckung des Insertstücks 1 mit dem Chip 2.

Auch im Ausführungsbeispiel von Fig. 9 ist das Insertstück mit dem Chip 2 allseitig spaltfrei in umgebendes Harzmaterial eingebettet, das in diesem Fall aus der Unterlagenschicht 7, der unteren Zwischenschichtlage 29 und der oberen Zwischenschichtlage 29b stammt und jegliche Spalte vor allem auch zwischen dem relativ dicken Chip 2 und den lateral angrenzenden Fensterrandbereichen der unteren Zwischenschichtlage 29 und der Innenlage 32 ausfüllt, indem es sich beim Verpressen oder Laminieren des Aufbaus verflüssigt und entsprechende Zwischenräume verfüllt.

Im gezeigten Beispiel von Fig. 9 dient der durch die Fenster 29a und 32a geschaffene Aufnahmeraum allein zum Aufnehmen des Chips 2. Es versteht sich, dass alternativ die Fenster mit lateralen Abmessungen vorgesehen sein können, die mindestens etwa denjenigen des übrigen Insertstücks 1, d.h. insbesondere des unter dem Chip 2 gelegenen Schichtaufbaus mit der Umverteilungsträgerschicht 3 entsprechen, um auch diesen Teil des Insertstücks 1 in einem Fensterbereich aufzunehmen, wenn hierfür Bedarf besteht. Dies ist insbesondere bei einem höheren Insertstück-Schichtaufbau zweckmäßig, wie beispielsweise bei Insertstücken des in Fig. 8 gezeigten Typs, speziell wenn dieser auch noch relativ dicke montierte Bauteile wie z.B. den Chip 2 von Fig. 9 beinhaltet.

Wenngleich in den gezeigten Beispielen jeweils nur ein Insertstück mit meist nur einem montierten elektrischen Bauteil in das Innere eines Leiterplatten-Mehrschichtaufbaus integriert ist, versteht es sich, dass die Erfindung in alternativen Ausführungsformen auch Leiterplatten-Mehrschichtaufbauten umfasst, in denen ein Insertstück mit mehreren auf ihm vorgesehenen, aktiven und/oder passiven elektrischen Bauteilen und/oder mehrere Insertstücke mit je einem oder mehreren elektrischen Bauteilen im Inneren des Schichtstapels integriert sind. Mehrere Insertstücke können beispielsweise in der gleichen Stapelebene mit lateralem Abstand nebeneinander positioniert sein. Zusätzlich oder alternativ können mehrere Insertstücke in Stapelrichtung übereinanderliegend in verschiedenen Stapelebenen mit oder ohne laterale Versetzung positioniert sein.

Die oben beschriebenen Ausführungsbeispiele machen deutlich, dass die Erfindung eine sehr vorteilhafte Integration einer oder mehrerer Insertstücke mit je einem oder mehreren passiven und/oder aktiven elektrischen Bauteilen auf einer Umverdrahtungsträgerschicht in das Innere eines Leiterplatten-Mehrschichtaufbaus ermöglicht, wobei das Insertstück und insbesondere dessen Umverdrahtungsträgerschicht vollständig und spaltfrei in Harzmaterial zwischen einer Unterlage und einer Decklage z.B. aus Prepregharzmaterial eingebettet wird. Der Aufbau des Insertstücks und dessen Einbau in den Schichtstapel lassen sich auf Wunsch mit hohem Symmetriegrad realisieren, was hohen mechanischen Spannungsbelastungen durch thermische Ausdehnungseffekte bei signifikanten Temperaturwechseln vorbeugt. Da die Umverdrahtungsträgerschicht des Inserts eine deutlich kleinere Flächenausdehnung aufweist als die einbettenden Schichtlagen des Leiterplatten-Schichtstapels treten keine Delaminationsprobleme auf, wie sie eventuell bei Einbringen einer durchgängigen Umverdrahtungsträgerschicht z.B. aus Polyimid zu befürchten wären. Eine flexible, dünne Auslegung der Umverdrahtungsträgerschicht kann weiter dazu beitragen, gemäß einer Interposer-Wirkung auftretende Zug- und Druckkraftbelastungen aufgrund unterschiedlicher thermischer Ausdehnungskoeffizienten der beteiligten Schichtmaterialen zu kompensieren. Eine im Wesentlichen mittige bzw. symmetrische Platzierung des oder der Bauteile auf der Umverdrahtungsträgerschicht des Inserts trägt ebenfalls zur Minderung lateraler Zug- und Druckkraftbelastungen bei.

Der erfindungsgemäße Leiterplatten-Mehrschichtaufbau ist erfindungsgemäß relativ einfach herstellbar. Die Umverdrahtungsträgerschicht und das oder die auf ihr montierten elektrischen Bauteile können vor dem Verpressen des Schichtstapels elektrisch geprüft werden, was die Fehlerquote verringert und die Ausbeute verbessert. Es werden nur elektrisch funktionsfähige Bauteile auf der Umverteilungsträgerschicht bestückt, und nur funktionierend bestückte Insertstücke werden in den Schichtstapel des Leiterplatten-Mehrschichtaufbaus verlegt und mit diesem verpresst. Durch das segmentierte Einbringen der Umverdrahtung nur in dem Teilbereich des Schichtstapels, in welchem sich das Insertstück zwischen der dielektrischen Unterlagenschicht und der dielektrischen Deckschicht befindet, lässt sich zudem insgesamt die Packungsdichte des Leiterplatten-Mehrschichtaufbaus steigern. Durch die erfindungsgemäße Umverdrahtung im Innern des Leiterplatten-Mehrschichtaufbaus kann zudem der Platzbedarf auf Außenlagen verringert werden, und die Entflechtung der Außenlagen vereinfacht sich, da nur noch entsprechende Durchkontakte von den Umverdrahtungskontaktstellen an die Oberfläche zu führen sind und die Position der Umverdrahtungskontaktstellen so gewählt werden kann, dass sich die zugehörigen Durchkontakte zu den Außenlagen an eine für die Entflechtung der Außenlagen optimalen Stelle befinden.

## Patentansprüche

1. Leiterplatten-Mehrschichtaufbau mit
- einem Schichtstapel aus mehreren elektrisch isolierenden und/oder mit Leiterbahnstrukturen versehenen Schichten (7, 9, 10, 11), wobei der Leiterplatten-Mehrschichtaufbau
- ein Insertstück (1) im Inneren des Schichtstapels aufweist, das sich lateral nur in einem Teilbereich der Flächenausdehnung des Schichtstapels erstreckt und wenigstens ein darauf montiertes, passives oder aktives elektrisches Bauteil (2) und eine zugehörige Umverdrahtung (4, 5) aufweist, und dass
- das Insertstück (1) zwischen zwei ganzflächigen, ausgehärteten, elektrisch isolierenden oder dielektrischen Harz-Schichten eingebettet ist, die das Insertstück beidseitig abdecken, wobei das Insertstück allseitig spaltfrei von Harzmaterial umschlossen ist, wobei die Harz-Schichten aus ausgehärteten Flüssigharz-Schichten oder Prepreg-Schichten (7, 9) gebildet sind
**dadurch gekennzeichnet, dass** dass Insertstüch im jeweiligen entspruchenden Ein drücken der zwei Harz-Schichten aufgenommen ist.

2. Leiterplatten-Mehrschichtaufbau nach Anspruch 1, weiter **dadurch gekennzeichnet, dass** wenigstens eine der beiden Flüssigharz- oder Prepeg-Schichten eine Ausnehmung (9a) im Bereich des Insertstücks oder wenigstens eines auf ihm montierten Bauteils aufweist, in die das Insertstück oder das Bauteil hineinragt.

3. Leiterplatten-Mehrschichtaufbau nach Anspruch 1 oder 2, weiter **dadurch gekennzeichnet, dass** zwischen den beiden Flüssigharz- oder Prepeg-Schichten wenigstens eine Flüssigharz- oder Prepeg-Zwischenschicht (29) vorgesehen ist, die ein Fenster (29a) im Bereich des Insertstücks oder wenigstens eines auf ihm montierten Bauteils aufweist.

4. Leiterplatten-Mehrschichtaufbau nach einem der Ansprüche 1 bis 3, weiter **dadurch gekennzeichnet, dass** wenigstens eine der beiden das Insertstück abdeckenden Flüssigharz- oder Prepeg-Schichten und/oder die Flüssigharz- oder Prepeg-Zwischenschicht mehrlagig mit wenigstens zwei Flüssigharz- oder Prepeg-Schichtlagen gebildet sind.

5. Leiterplatten-Mehrschichtaufbau nach einem der Ansprüche 1 bis 4, weiter **dadurch gekennzeichnet, dass** sich zwischen den beiden das Insertstück abdeckenden Flüssigharz- oder Prepeg-Schichten (7, 9) wenigstens eine mit Leiterbahnstrukturen versehene Schicht (32) befindet, die ein Fenster (32a) im Bereich des Insertstücks oder wenigstens eines auf ihm montierten Bauteils aufweist.

6. Leiterplatten-Mehrschichtaufbau nach einem der Ansprüche 1 bis 5, weiter **dadurch gekennzeichnet, dass** das jeweilige elektrische Bauteil (2) auf einem Bauteilmontageplatz einer Umverdrahtungsträgerschicht (3) montiert ist, auf der auch die Umverdrahtung (4, 5) vorgesehen ist.

7. Leiterplatten-Mehrschichtaufbau nach Anspruch 6, weiter **dadurch gekennzeichnet, dass** die Umverdrahtung (4, 5) auf der gleichen Seite der Umverdrahtungsträgerschicht (3) wie der Bauteilmontageplatz vorgesehen ist.

8. Leiterplatten-Mehrschichtaufbau nach Anspruch 6 oder 7, weiter **dadurch gekennzeichnet, dass** beidseits der Umverdrahtungsträgerschicht je eine Umverdrahtung und jeweils wenigstens ein auf dem Insertstück montiertes, passives oder aktives elektrisches Bauteil (2, 2a, 2b, 2c) vorgesehen sind.

9. Leiterplatten-Mehrschichtaufbau nach einem der Ansprüche 6 bis 8, weiter **dadurch gekennzeichnet, dass** die Umverdrahtungsträgerschicht aus einem flexiblen Leiterplattenmaterial, insbesondere einem Flüssigkristallpolymer-Material oder Polyimidmaterial, oder einem Keramikmaterial gebildet ist und den Bauteilmontageplatz zum Montieren des wenigstens einen elektrischen Bauteils in einem mittleren Bereich sowie Umverdrahtungskontaktstellen (4) in einem peripheren Bereich und Umverdrahtungsleiterbahnen (5) aufweist, die zwischen dem Bauteilmontageplatz und den Umverdrahtungskontaktstellen (4) verlaufen.

10. Leiterplatten-Mehrschichtaufbau nach einem der Ansprüche 1 bis 9, weiter **dadurch gekennzeichnet, dass** zwischen dem Insertstück und wenigstens einer der beiden das Insertstück abdeckenden Flüssigharz- oder Prepreg-Schichten (7, 9) ein jeweiliges Pufferschichtstück vorgesehen ist.

11. Leiterplatten-Mehrschichtaufbau nach einem der Ansprüche 6 bis 10, weiter **gekennzeichnet durch** eine Höhenabstandshalterstruktur (18) auf der Umverdrahtungsträgerschicht (3) im Bereich lateral außerhalb des wenigstens einen elektrischen Bauteils (2), wobei sich die Höhenabstandshalterstruktur (18) in Stapelrichtung mindestens so weit wie das wenigstens eine elektrische Bauteil (2) erstreckt.

12. Leiterplatten-Mehrschichtaufbau nach einem der Ansprüche 6 bis 11, weiter **dadurch gekennzeichnet, dass** das Insertstück (1) eine Füll- und/oder Planarisierungsschicht aufweist, die sich ganzflächig oder nur im Bereich außerhalb des oder der elektrischen Bauteile (2) über der Umverdrahtungsträgerschicht (3) erstreckt.

13. Leiterplatten-Mehrschichtaufbau nach Anspruch 12, weiter **dadurch gekennzeichnet, dass** die Füll- und/oder Planarisierungsschicht aus einem wärmeleitfähigen, elektrisch isolierenden Material besteht.

14. Leiterplatten-Mehrschichtaufbau nach Anspruch 13, weiter **dadurch gekennzeichnet, dass** das Insertstück eine Wärmeleitschicht über der Füll- und/oder Planarisierungsschicht aufweist.

15. Leiterplatten-Mehrschichtaufbau nach einem der Ansprüche 12 bis 14, weiter **dadurch gekennzeichnet, dass** das Insertstück (1) eine zur Umverdrahtungsträgerschicht (3) material- und/oder größenbezogen gleichartige Deckschicht über der Füll- und/oder Planarisierungsschicht oder über der Wärmeleitschicht aufweist.

16. Leiterplatten-Mehrschichtaufbau nach Anspruch 14 oder 15, weiter **dadurch gekennzeichnet, dass** die Wärmeleitschicht über einen oder mehrere Durchkontakte (17a, 17b) mit wenigstens einer wärmeleitfähigen, strukturierten oder ganzflächigen Schicht des Schichtstapels wärmeleitend verbunden ist.

17. Leiterplatten-Mehrschichtaufbau nach einem der Ansprüche 9 bis 16, weiter **dadurch gekennzeichnet, dass** wenigstens eine der Umverdrahtungskontaktstellen (4) über einen oder mehrere Durchkontakte (17a, 17b) mit wenigstens einer wärmeleitfähigen, strukturierten oder ganzflächigen Schicht des Schichtstapels wärmeleitend verbunden ist.

18. Leiterplatten-Mehrschichtaufbau nach einem der Ansprüche 1 bis 17, weiter **dadurch gekennzeichnet, dass** sich die das Insertstück (1) abdeckenden Flüssigharz- oder Prepeg-Schichten (7, 9) in Stapelrichtung etwa mittig im Schichtstapel befinden.

19. Verfahren zur Herstellung eines Leiterplatten-Mehrschichtaufbaus nach einem der Ansprüche 1 bis 18,
mit folgenden Schritten:
- Bereitstellen des Insertstücks (1) mit dem elektrischen Bauteil (2) und der zugehörigen Umverdrahtung (4, 5),
- Anordnen des Insertstücks (1) an einer vorbereiteten Unterlagenschicht (7) des Schichtstapels und Anordnen der einen oder mehreren weiteren Schichten des Schichtstapels über der Unterlagenschicht (7) und dem Insertstück (1), wobei für die Unterlagenschicht (7) und eine das Insertstück (1) auf der gegenüberliegenden Seite abdeckende Schicht (9) jeweils eine Flüssigharz- oder Prepreg-Schichtlage gewählt wird, und
- Zusammenlaminieren und/oder Verpressen des so vorbereiteten Gesamtaufbaus, wobei sich das Harzmaterial in an das Insertstück angrenzenden Flüssigharz- oder Prepeg-Schichtbereichen beim Laminieren oder Verpressen des Aufbaus verflüssigt und das Insertstück allseitig spaltfrei umschließt.

20. Verfahren nach Anspruch 19, weiter **dadurch gekennzeichnet, dass** das elektrische Bauteil (2) auf der Umverdrahtungsträgerschicht (3) des Insertstücks (1) montiert wird und die Umverdrahtungsträgerschicht (3) vor Einbringen des Insertstücks (1) in den Schichtstapel mit Bohrungen versehen wird, die sich beim nachfolgenden Laminierungs-/Verpressungsprozess mit Harzmaterial aus der Umgebung füllen, und anschließend Durchkontakte (17a, 17b) in den harzgefüllten Bohrungen mit gegenüber den Bohrungen geringerem Durchmesser derart erzeugt werden, dass zwischen dem jeweiligen Durchkontakt und dem benachbarten Rand der Umverdrahtungsträgerschicht (3) ein Harzmaterialring verbleibt.

21. Verfahren nach Anspruch 19 oder 20, weiter **dadurch gekennzeichnet, dass** Umverdrahtungsleiterbahnen dadurch gebildet werden, dass auf die Umverdrahtungsträgerschicht (3) ganzflächig eine elektrisch leitende Umverdrahtungsschicht aufgebracht und anschließend durch Bilden von Trenngräben in flächige Leiterbahnen unter Beibehaltung eines überwiegenden Flächenanteils der Umverdrahtungsschicht aufgeteilt wird.

22. Leiterplatten-Mehrschichtaufbau nach einem der Ansprüche 1 bis 18, weiter **dadurch gekennzeichnet, dass** der Leiterplatten-Mehrschichtaufbau mindestens zwei äußere Leiterstrukturebenen (16a, 16b) aufweist, zwischen denen sich durch den gesamten Schichtstapel hindurch Durchkontakte (17a, 17b) erstrecken, die gleichzeitig zugehörige Umverdrahtungskontaktstellen (4a, 4b) kontaktieren und dadurch eine elektrische Verbindung zugehöriger Anschlüsse des Bauteils (2) nach außen herstellen.

23. Leiterplatten-Mehrschichtaufbau nach Anspruch 22, weiter **dadurch gekennzeichnet, dass** der Leiterplatten-Mehrschichtaufbau mindestens eine innere Leiterstrukturebene (15a bis 15d) aufweist, wobei eine Kontaktierung der verschiedenen Leiterstrukturebenen (15a bis 15d, 16a, 16b) sowie des Bauteils (2) auf dem Insertstück (1) über die Durchkontakte (17a, 17b) erfolgt.

24. Verfahren nach Anspruch 19, 20 oder 21, weiter **dadurch gekennzeichnet, dass** mindestens zwei äußere Leiterstrukturebenen (16a, 16b) und Durchkontakte (17a, 17b) vorgesehen werden, wobei sich die Durchkontakte (17a, 17b) zwischen den zwei äußeren Leiterstrukturebenen durch den gesamten Schichtstapel hindurch erstrecken, und die Durchkontakte (17a, 17b) gleichzeitig zugehörige Umverdrahtungskontaktstellen (4a, 4b) kontaktieren und dadurch eine elektrische Verbindung zugehöriger Anschlüsse des Bauteils (2) nach außen herstellen.

25. Verfahren nach Anspruch 24, weiter **dadurch gekennzeichnet, dass** mindestens eine innere Leiterstrukturebene (15a bis 15d) vorgesehen wird, wobei eine Kontaktierung der verschiedenen Leiterstrukturebenen (15a bis 15d, 16a, 16b) sowie des Bauteils (2) auf dem Insertstück (1) über die Durchkontakte (17a, 17b) erfolgt.

## Claims

1. Multilayer printed circuit board structure, comprising:
- a layer stack of several layers (7, 9, 10, 11) which are electrically isolating and/or provided with conductor line structures, wherein
- the multilayer printed circuit board structure comprises an insert piece (1) in the interior of the layer stack laterally extending only in a portion of the surface extension of the layer stack and having at least one passive or active electric component (2) mounted thereon and a corresponding wiring (4, 5), and
- the insert piece (1) is embedded between two hardened electrically isolating or dielectric resin layers covering the entire surface on both sides of the insert piece, wherein the insert piece is enclosed without a gap by resin material and wherein the resin layers are made of hardened liquid resin layers or prepreg layers (7, 9),
**characterized in that** the insert piece is received in respective corresponding moldings of the two resin layers.

2. Multilayer printed circuit board structure according to Claim 1, further **characterized in that** at least one of the two liquid resin or prepreg layers has a recess (9a) in the region of the insert piece or of at least one component mounted thereon into which the insert piece or the component protrudes.

3. Multilayer printed circuit board structure according to Claim 1 or 2, further **characterized in that** between the two liquid resin or prepreg layers at least one liquid resin or prepreg intermediate layer (29) is provided which has a window (29a) in the region of the insert piece or of at least one component mounted thereon.

4. Multilayer printed circuit board structure according to one of Claims 1 to 3, further **characterized in that** at least one of the two liquid resin or prepreg layers covering the insert piece and/or the liquid resin or prepreg intermediate layer are multilayer-formed with at least two liquid resin or prepreg film layers.

5. Multilayer printed circuit board structure according to one of Claims 1 to 4, further **characterized in that** between the two liquid resin or prepreg layers (7, 9) covering the insert piece, at least one layer (32) provided with conductor line structures is disposed having a window (32a) in the region of the insert piece or of at least one component mounted thereon.

6. Multilayer printed circuit board structure according to one of Claims 1 to 5, further **characterized in that** the respective electric component (2) is mounted on a component mounting location of a wiring support layer (3) on which also the wiring (4, 5) is provided.

7. Multilayer printed circuit board structure according to Claim 6, further **characterized in that** the wiring (4, 5) is provided on the same side of the wiring support layer (3) as the component mounting location.

8. Multilayer printed circuit board structure according to Claim 6 or 7, further **characterized in that** on both sides of the wiring support layer, a wiring and a respective at least one passive or active electric component (2, 2a, 2b, 2c) mounted on the insert piece is provided.

9. Multilayer printed circuit board structure according to one of Claims 6 to 8, further **characterized in that** the wiring support layer is made of a flexible printed circuit board material, in particular a liquid-crystal polymer material or a polyimide material or a ceramic material, and includes the component mounting location for mounting the at least one electric component in a middle region and wiring pads (4) in a peripheral region, and wiring conductor lines (5) running between the component mounting location and the wiring pads (4).

10. Multilayer printed circuit board structure according to one of Claims 1 to 9, further **characterized in that** between the insert piece and at least one of the two liquid resin or prepreg layers (7, 9) covering the insert piece, a respective buffer layer piece is provided.

11. Multilayer printed circuit board structure according to one of Claims 6 to 10, further **characterized by** a height spacer structure (18) on the wiring support layer (3) in the region laterally outside the at least one electric component (2), wherein the height spacer structure (18) extends in the stacking direction at least as far as the at least one electric component (2).

12. Multilayer printed circuit board structure according to one of Claims 6 to 11, further **characterized in that** the insert piece (1) has a fill layer and/or a planarization layer extending over the entire surface or only in the region outside the one or more electric components (2) over the wiring support layer (3).

13. Multilayer printed circuit board structure according to Claim 12, further **characterized in that** the fill layer and/or planarization layer is made of a heat conductive, electrically isolating material.

14. Multilayer printed circuit board structure according to Claim 13, further **characterized in that** the insert piece comprises a heat conducting layer over the fill layer and/or planarization layer.

15. Multilayer printed circuit board structure according to one of Claims 12 to 14, further **characterized in that** the insert piece (1) comprises a cover layer having the same material and/or the same dimensions as the wiring support layer (3) over the fill layer and/or planarization layer or over the heat conducting layer.

16. Multilayer printed circuit board structure according to Claim 14 or 15, further **characterized in that** the heat conducting layer is connected by one or several vias (17a, 17b) to at least one layer of the layer stack in a heat-conductive manner, the layer being heat conductive, structured or covering the entire surface.

17. Multilayer printed circuit board structure according to one of Claims 9 to 16, further **characterized in that** at least one of the wiring pads (4) is connected by one or several vias (17a, 17b) to at least one layer of the layer stack in a heat-conductive manner, the layer being heat conductive, structured or covering the entire surface.

18. Multilayer printed circuit board structure according to one of Claims 1 to 17, further **characterized in that** the liquid resin or prepreg layers (7, 9) covering the insert piece (1) are located in stacking direction approximately in the middle of the layer stack.

19. Method for producing a multilayer printed circuit board structure according to one of Claims 1 to 18, comprising the following steps:
- providing the insert piece (1) with the electric component (2) and the corresponding wiring (4, 5),
- arranging the insert piece (1) at a prepared base layer (7) of the layer stack and arranging the one or several further layers of the layer stack over the base layer (7) and the insert piece (1), wherein a respective liquid resin or prepreg film layer is selected for the base layer (7) and a layer (9) covering the insert piece (1) on the opposite side, and
- laminating and/or pressing the thus prepared assembly together, wherein the resin material in liquid resin or prepreg layer regions adjacent to the insert piece liquefies in the process of laminating or pressing the assembly and encloses the insert piece on all sides without a gap.

20. Method according to Claim 19, further **characterized in that** the electric component (2) is mounted on the wiring support layer (3) of the insert piece (1) and that the wiring support layer (3) is provided with bores before the insert piece (1) is introduced into the layer stack, the bores filling with resin material from the surroundings in the subsequent lamination/pressing process, and that subsequently vias (17a, 17b) are generated in the resin filled bores having a lower diameter than the bores such that between the respective via and the adjacent border of the wiring support layer (3) a resin material ring remains.

21. Method according to Claim 19 or 20, further **characterized in that** wiring conductor lines are formed by applying an electrically conductive wiring layer onto the entire surface of the wiring support layer (3) and subsequently dividing the wiring layer by forming separation trenches in planar conductor lines while maintaining a major surface ratio of the wiring layer.

22. Multilayer printed circuit board structure according to one of Claims 1 to 18, further **characterized in that** the multilayer printed circuit board structure comprises at least two exterior conductor structure planes (16a, 16b) between which vias (17a, 17b) extend through the entire layer stack, the vias simultaneously contacting associated wiring pads (4a, 4b) and thus forming an electric connection of associated connectors of the component (2) to the outside.

23. Multilayer printed circuit board structure according to Claim 22, further **characterized in that** the multilayer printed circuit board structure comprises at least one interior conductor structure plane (15a to 15d), wherein a contacting of the different conductor structure planes (15a to 15d, 16a, 16b) and of the component (2) on the insert piece (1) is performed by the vias (17a, 17b).

24. Method according to Claim 19, 20 or 21, further **characterized in that** at least two exterior conductor structure planes (16a, 16b) and vias (17a, 17b) are provided, wherein the vias (17a, 17b) extend between the two exterior conductor structure planes through the entire layer stack and wherein the vias (17a, 17b) simultaneously contact associated wiring pads (4a, 4b) and thus form an electric connection of associated connectors of the component (2) to the outside.

25. Method according to Claim 24, further **characterized in that** at least one interior conductor structure plane (15a to 15d) is provided, wherein a contacting of the different conductor structure planes (15a to 15d, 16a, 16b) and of the component (2) on the insert piece (1) is performed by the vias (17a, 17b).

## Revendications

1. Structure multicouches pour carte à circuits, comprenant
- un empilement de couches formé de plusieurs couches (7, 9, 10, 11) électriquement isolantes et/ou pourvues de structures de pistes conductrices,
dans laquelle la structure multicouches pour carte à circuits
- comprend une pièce en insert (1) à l'intérieur de l'empilement de couches, qui s'étend latéralement uniquement dans une région partielle de l'extension surfacique de l'empilement de couches et qui comprend au moins un composant électrique (2), passif ou actif, monté sur cette pièce, et un fils d'enrobage associé (4, 5), et en ce que
- la pièce en insert (1) est noyée sur toute la surface entre deux couches en résine durcie, électriquement isolantes ou diélectriques, qui recouvrent la pièce en insert sur les deux côtés, ladite pièce en insert étant enfermée de tous les côtés sans intervalle par le matériau en résine, et les couches en résine sont formées par des couches en résine liquide durcie ou des couches en préimprégné (7, 9),
**caractérisée en ce que** la pièce en insert est reçue dans des creux respectifs correspondants des deux couches en résine.

2. Structure multicouches pour carte à circuits selon la revendication 1, **caractérisée en outre en ce que** l'une au moins des deux couches en résine liquide ou en préimprégné comporte un évidement (9a) dans la région de la pièce en insert ou d'au moins un composant monté sur celle-ci, dans lequel pénètre la pièce en insert ou le composant.

3. Structure multicouches pour carte à circuits selon la revendication 1 ou 2, **caractérisée en outre en ce qu'**il est prévu entre les deux couches en résine liquide ou en préimprégné au moins une couche intermédiaire en résine liquide ou en préimprégné (29), qui comporte une fenêtre (29a) dans la région de la pièce en insert ou d'au moins un composant monté sur celle-ci.

4. Structure multicouches pour carte à circuits selon l'une des revendications 1 à 3, **caractérisée en outre en ce que** l'une au moins des deux couches en résine liquide ou en préimprégné qui recouvre la pièce en insert, et/ou la couche intermédiaire en résine liquide ou en préimprégné est/sont formée(s) à plusieurs nappes avec au moins deux nappes en résine liquide ou en préimprégné.

5. Structure multicouches pour carte à circuits selon l'une des revendications 1 à 4, **caractérisée en outre en ce qu'**il se trouve entre les deux couches en résine liquide ou en préimprégné (7, 9) qui recouvrent la pièce en insert au moins une couche dotée de structures formant pistes conductrices (32), qui comporte une fenêtre (32a) dans la région de la pièce en insert ou d'au moins un composant monté sur celle-ci.

6. Structure multicouches pour carte à circuits selon l'une des revendications 1 à 5, **caractérisée en outre en ce que** le composant électrique respectif (2) est monté sur un emplacement de montage pour composant d'une couche porteuse (3) pour câblage extérieur, sur laquelle est également prévu le câblage extérieur (4, 5).

7. Structure multicouches pour carte à circuits selon la revendication 6, **caractérisée en outre en ce que** le câblage extérieur (4, 5) est prévu sur le même côté de la couche porteuse (3) pour câblage extérieur que l'emplacement de montage pour composant.

8. Structure multicouches pour carte à circuits selon la revendication 6 ou 7, **caractérisée en outre en ce qu'**il est prévu des deux côtés de la couche porteuse respectivement un câblage extérieur et respectivement au moins un composant électrique passif ou actif (2, 2a, 2b, 2c) monté sur la pièce en insert.

9. Structure multicouches pour carte à circuits selon l'une des revendications 6 à 8, **caractérisée en outre en ce que** la couche porteuse pour câblage extérieur est formée en un matériau flexible pour carte à circuits, en particulier un matériau en polymère à cristaux liquides ou un matériau en polyimide, ou encore un matériau céramique, et comporte dans une région médiane l'emplacement de montage pour le montage dudit au moins un composant électrique et dans une région périphérique des emplacements de contact (4) pour câblage extérieur, ainsi que des pistes conductrices (5) pour câblage extérieur, qui s'étendent entre l'emplacement de montage pour composant et les emplacements de contact (4) pour câblage extérieur.

10. Structure multicouches pour carte à circuits selon l'une des revendications 1 à 9, **caractérisée en outre en ce qu'**il est prévu une pièce respective formant couche tampon entre la pièce en insert et l'une au moins des deux couches en résine liquide ou en préimprégné (7, 9) qui recouvrent la pièce en insert.

11. Structure multicouches pour carte à circuits selon l'une des revendications 6 à 10, **caractérisée en outre par** une structure de maintien d'écartement en hauteur (18) sur la couche porteuse (3) pour câblage extérieur, dans la région latéralement à l'extérieur dudit au moins un composant électrique (2), ladite structure de maintien d'écartement en hauteur (18) s'étendant en direction d'empilement au moins aussi loin que ledit au moins un composant électrique (2).

12. Structure multicouches pour carte à circuits selon l'une des revendications 6 à 11, **caractérisée en outre en ce que** la pièce en insert (1) comprend une couche de remplissage et/ou une couche de planéité, qui s'étend sur toute la surface ou seulement dans la région à l'extérieur du ou des composant(s) électrique(s) (2) au-dessus de la couche porteuse (3) pour câblage extérieur.

13. Structure multicouches pour carte à circuits selon la revendication 12, **caractérisée en outre en ce que** la couche de remplissage et/ou de planéité est en un matériau conducteur de la chaleur et électriquement isolant.

14. Structure multicouches pour carte à circuits selon la revendication 13, **caractérisée en outre en ce que** la pièce en insert comprend une couche conductrice de la chaleur au-dessus de la couche de remplissage et/ou de planéité.

15. Structure multicouches pour carte à circuits selon l'une des revendications 12 à 14, **caractérisée en outre en ce que** la pièce en insert (1) comprend, au-dessus de la couche de remplissage et/ou de planéité ou au-dessus de la couche conductrice de la chaleur, une couche de couverture de type analogue à la couche porteuse (3) pour le câblage extérieur pour ce qui concerne le matériau et/ou la taille.

16. Structure multicouches pour carte à circuits selon la revendication 14 ou 15, **caractérisée en outre en ce que** la couche conductrice de la chaleur est reliée de manière à conduire la chaleur via un ou plusieurs contacts traversants (17a, 17b) avec au moins une couche conductrice de la chaleur, structurée ou sur toute la surface, de l'empilement de couches.

17. Structure multicouches pour carte à circuits selon l'une des revendications 9 à 16, **caractérisée en outre en ce que** l'un au moins des emplacements de contact (4) pour câblage extérieur est relié de manière à conduire la chaleur via un ou plusieurs contacts traversants (17a, 17b) avec au moins une couche conductrice de la chaleur, structurée ou sur toute la surface, de l'empilement de couches.

18. Structure multicouches pour carte à circuits selon l'une des revendications 1 à 17, **caractérisée en outre en ce que** les couches en résine liquide ou en préimprégné (7, 9) qui recouvrent la pièce en insert (1) se trouvent approximativement au milieu dans l'empilement de couches, dans la direction d'empilement.

19. Procédé pour la fabrication d'une structure multicouche pour carte à circuits selon l'une des revendications 1 à 18, comprenant les étapes suivantes consistant à :
- préparer la pièce en insert (1) avec le composant électrique (2) et le câblage extérieur (4, 5) associé,
- agencer la pièce en insert (1) sur une couche d'appui préparée (7) de l'empilement de couches, et agencer lesdites une ou plusieurs autres couches de l'empilement de couches au-dessus de la couche d'appui (7) et de la pièce en insert (1), en choisissant pour la couche d'appui (7) et une couche (9) qui recouvre la pièce en insert (1) sur le côté opposé, une nappe de couche respective en résine liquide ou en préimprégné, et
- laminer conjointement et/ou presser la structure globale ainsi préparée, de sorte que le matériau en résine dans les zones des couches en résine liquide ou en préimprégné adjacentes à la pièce en insert devient liquide lors du laminage ou du pressage de la structure et enferme la pièce en insert sans intervalle sur tous les côtés.

20. Procédé selon la revendication 19, **caractérisé en outre en ce que** le composant électrique (2) est monté sur la couche porteuse (3) pour câblage extérieur de la pièce en insert (1) et, avant l'introduction de la pièce en insert (1) dans l'empilement de couches, la couche porteuse (3) pour câblage extérieur est pourvue de perçage qui, lors du processus de laminage/pressage successif, se remplissent de matériau en résine provenant de l'environnement, et on réalise ensuite des contacts traversants (17a, 17b) dans les perçages remplis de résine avec un diamètre plus faible par rapport aux perçages de telle façon qu'il demeure une bague en résine entre le contact traversant respectif et la bordure voisine de la couche porteuse (3) pour câblage extérieur.

21. Procédé selon la revendication 19 20, **caractérisé en outre en ce que** les pistes conductrices du câblage extérieur sont formées en appliquant sur la couche porteuse (3) pour câblage extérieur sur toute la surface une couche formant câblage extérieur électriquement conductrice et on subdivise ensuite la couche formant câblage extérieur en réalisant des fossés de séparation dans les pistes conductrices surfaciques en conservant une proportion surfacique importante de la couche formant câblage extérieur.

22. Structure multicouches pour carte à circuits selon l'une des revendications 1 à 18, **caractérisée en outre en ce que** la structure multicouches pour carte à circuits comporte au moins deux plans de structure conductrice extérieure (16a, 16b), entre lesquels s'étendent des contacts traversants (17a, 17b) qui traversent la totalité de l'empilement de couches et qui mettent simultanément en contact des emplacements de contacts associés (4a, 4b) du câblage extérieur et établissent ainsi une liaison électrique des bornes associées du composant (2) vers l'extérieur.

23. Structure multicouches pour carte à circuits selon la revendication 22, **caractérisée en outre en ce que** la structure multicouches pour carte à circuits comporte au moins un plan intérieur de structure conductrice (15a à 15d), et une mise en contact des différents plans de structure conductrice (15a à 15d, 16a, 16b) ainsi que du composant (2) sur la pièce en insert (1) a lieu via les contacts traversants (17a, 17b).

24. Procédé selon la revendication 19, 20 août 21, **caractérisé en outre en ce qu'**il est prévu au moins deux plans extérieurs de structure conductrice (16a, 16b) et des contacts traversants (17a, 17b), lesdits contacts traversants (17a, 17b) s'étendant entre les deux plans extérieurs de structure conductrice en traversant la totalité de l'empilement de couches, et les contacts traversants (17a, 17b) mettent simultanément en contact des emplacements de contacts associés (4a, 4b) du câblage extérieur et établissent ainsi une liaison électrique des bornes associées du composant (2) vers l'extérieur.

25. Procédé selon la revendication 24, **caractérisé en outre en ce qu'**il est prévu au moins un plan intérieur de structure conductrice (15a à 15d), et une mise en contacts des différents plans de structure conductrice (15a à 15d, 16a, 16b) ainsi que du composant (2) sur la pièce en insert (1) a lieu via les contacts traversants (17a, 17b).
